(19) Europäisches Patentamt
European Patent Office
Office européen des brevets

(11) **EP 2 315 338 B1**

(12) **EUROPÄISCHE PATENTSCHRIFT**

(45) Veröffentlichungstag und Bekanntmachung des Hinweises auf die Patenterteilung:
**15.08.2018   Patentblatt 2018/33**

(51) Int Cl.:
***H02J 9/00*** *(2006.01)*

(21) Anmeldenummer: **10188022.7**

(22) Anmeldetag: **19.10.2010**

(54) **(Stand-by)-Schaltungsanordnung zum Betreiben eines Haushaltsgeräts und entsprechendes Verfahren**

(Stand-by) switching assembly for operating a household device and method for same

Agencement de commutation (à l'arrêt) destiné au fonctionnement d'un appareil ménager et procédé correspondant

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.10.2009   DE 102009045967**

(43) Veröffentlichungstag der Anmeldung:
**27.04.2011   Patentblatt 2011/17**

(73) Patentinhaber: **BSH Hausgeräte GmbH**
**81739 München (DE)**

(72) Erfinder:
• **Hajduk, Lubos**
**07211, Michalovce (SK)**
• **Piermeier, Simon**
**94379, Sankt Englmar (DE)**

(56) Entgegenhaltungen:
**US-A- 5 834 857     US-A1- 2009 224 603**

**Beschreibung**

Die Erfindung betrifft eine Schaltungsanordnung zum Betreiben eines Haushaltsgeräts. Die Schaltungsanordnung umfasst einen Schaltungseingang mit einem ersten und einem zweiten Eingangsanschluss zum Koppeln der Schaltungsanordnung mit einem elektrischen Versorgungsnetz, wobei an den Schaltungseingang eine Versorgungswechselspannung des Versorgungsnetzes anlegbar ist. Die Schaltungsanordnung umfasst auch eine Spannungsversorgungseinheit, die zum Bereitstellen einer Betriebsgleichspannung aus der Versorgungswechselspannung ausgebildet ist und die einen Energiespeicher aufweist, an welchem die Betriebsgleichspannung anliegt. Die Schaltungsanordnung umfasst außerdem eine zwischen dem Schaltungseingang und der Spannungsversorgungseinheit gekoppelte Schalteinheit, die zwischen einem Koppelzustand, in welchem die Spannungsversorgungseinheit mit dem Schaltungseingang elektrisch gekoppelt ist, und einem Entkoppelzustand, in welchem die Spannungsversorgungseinheit von dem Schaltungseingang entkoppelt ist, schaltbar ist. Darüber hinaus umfasst die Schaltungsanordnung eine Steuereinrichtung zum Ansteuern der Schalteinheit sowie eine mit der Steuereinrichtung gekoppelte Bedieneinrichtung, mittels welcher die Schaltungsanordnung zwischen einem Wartezustand (Stand-by-Zustand) und einem Aktivzustand überführbar ist. Die Steuereinrichtung und die Bedieneinrichtung sind mit elektrischer Energie aus dem Energiespeicher versorgbar. Die Erfindung betrifft außerdem ein Haushaltsgerät mit einer solchen Schaltungsanordnung sowie ein Verfahren zum Betreiben eines Haushaltsgeräts mit Hilfe einer solchen Schaltungsanordnung.

Es geht vorliegend um das Sparen von elektrischer Energie. Es ist bekannt, dass Haushaltsgeräte zwischen einem Aktivzustand, in welchem elektrische Energie für elektrische Verbraucher des Haushaltsgeräts bereitgestellt ist, und einem Wartezustand (Stand-by-Zustand), in welchem lediglich eine für einen extrem niedrigen Strombedarf ausgelegte Steuereinrichtung sowie eine Bedieneinrichtung mit elektrischer Energie versorgt werden, geschaltet werden können. In diesem Zusammenhang sind Schaltungsanordnungen bekannt, die das Überführen eines Haushaltsgeräts zwischen dem Aktivzustand und dem Wartezustand ermöglichen.

Aus der Druckschrift EP 0 689 351 A2 ist eine Schaltungsanordnung für ein fernbedienbares elektronisches Gerät, wie einen Fernsehempfänger oder einen Hörrundfunkempfänger, bekannt. Diese Schaltungsanordnung kann zwischen einem Aktivzustand und einem Wartezustand geschaltet werden. Im Wartezustand ist ein Netzteil, welches zum Bereitstellen von elektrischer Energie für elektrische Verbraucher des Geräts dient, von einem Schaltungseingang entkoppelt. Beim Überführen der Schaltungsanordnung in den Aktivzustand wird das Netzteil mit dem Schaltungseingang gekoppelt und mit der Versorgungswechselspannung versorgt. Im Wartezustand greift ein weiteres Netzteil die Versorgungswechselspannung am Schaltungseingang ab und stellt eine Gleichspannung bereit, mit welcher ein Fernbedienempfänger versorgt wird. Dieser Fernbedienempfänger kann Signale empfangen, die das Überführen der Schaltungsanordnung zwischen dem Wartezustand und dem Aktivzustand veranlassen.

Die Druckschrift US 2009/224603 A1 offenbart ein Stromversorgungsgerät, welches neben zwei für unterschiedliche Leistungsbereiche ausgelegten Netzteilen, die jeweils über ein Relais mit dem Netzeingang gekoppelt sind, einen Energiespeicher aufweist, der zur Eigenversorgung des Stromversorgungsgeräts im vollständig abgekoppelten Zustand dient. An einem gemeinsamen Ausgang der beiden Netzteile, welche über Dioden miteinander gekoppelt sind, ist ein externer Verbraucher anschließbar, beispielsweise ein Laptop. Wenn der Verbraucher an den Ausgang angeschlossen ist und daraus Strom entnimmt, wird dies über einen Stromwächter detektiert. Je nach Belastungsfall werden dann die Relais, welche als Öffner ausgebildet sind, entsprechend geschaltet. Bei nicht angeschlossenem oder inaktivem Verbraucher sowie voll aufgeladenem Energiespeicher befindet sich das Stromversorgungsgerät in einem vollständig abgekoppelten Zustand, die Steuerkreise der dann geöffneten Relais werden in diesem Zustand aus dem Energiespeicher bestromt.

Es ist Aufgabe der Erfindung, eine Lösung aufzuzeigen, wie ein Haushaltsgerät in einem Wartezustand (Stand-by-Zustand) besonders energieeffizient betrieben werden kann.

Diese Aufgabe wird erfindungsgemäß durch eine Schaltungsanordnung mit den Merkmalen gemäß Patentanspruch 1, durch ein Haushaltsgerät mit den Merkmalen gemäß Patentanspruch 12, wie auch durch ein Verfahren mit den Merkmalen des Patentanspruchs 13 gelöst. Vorteilhafte Ausführungen der Erfindung sind Gegenstand der abhängigen Patentansprüche.

Eine erfindungsgemäße Schaltungsanordnung ist zum Betreiben eines Haushaltsgeräts ausgebildet. Die Schaltungsanordnung umfasst einen Schaltungseingang mit einem ersten und einem zweiten Eingangsanschluss zum Koppeln der Schaltungsanordnung mit einem elektrischen Versorgungsnetz, wobei an den Schaltungseingang eine Versorgungswechselspannung des Versorgungsnetzes angelegt werden kann. Eine Spannungsversorgungseinheit stellt eine Betriebsgleichspannung aus der Versorgungswechselspannung bereit und weist einen Energiespeicher auf, an welchem die Betriebsgleichspannung anliegt. Eine zwischen dem Schaltungseingang und der Spannungsversorgungseinheit gekoppelte Schalteinheit ist zwischen einem Koppelzustand, in welchem die Spannungsversorgungseinheit mit dem Schaltungseingang elektrisch gekoppelt ist, und einem Entkoppelzustand, in welchem die Spannungsversorgungseinheit von dem Schaltungseingang entkoppelt ist, schaltbar. Zum Ansteuern der Schalteinheit ist eine Steuereinrichtung vorgesehen, die mit elektrischer Energie aus dem Energiespeicher versorgt wird. Mit der Steuereinrichtung ist eine Bedieneinrichtung gekoppelt, die mit elektrischer Energie aus dem Energiespeicher versorgt wird und mittels welcher die Schaltungsanordnung zwischen einem Wartezustand und einem Aktivzustand überführt werden kann. Die Steuereinrichtung ist dazu ausgelegt, nach Aufladen des Energiespeichers in dem Wartezustand der Schaltungsanordnung die Schalteinheit in den Entkoppelzustand zu überführen.

Demnach wird ein energieeffizientes Betreiben des Haushaltsgeräts in dem Wartezustand dadurch erzielt, dass die Schalteinheit nur für die Zeitdauer des Vorgangs des Aufladens des Energiespeichers in dem Koppelzustand gehalten und nach Aufladen des Energiespeichers in den Entkoppelzustand überführt wird. Die Spannungsversorgungseinheit verbraucht somit nur während des Vorgangs des Aufladens des Energiespeichers elektrische Energie von dem elektrischen Versorgungsnetz; ansonsten ist sie von dem elektrischen Versorgungsnetz entkoppelt. Die Erfindung macht sich die Tatsache zu Nutze, dass der Vorgang des Aufladens des Energiespeichers - je nach seiner Dimensionierung - wenige Sekunden dauert und die im Energiespeicher enthaltene Energie für eine deutlich längere Zeit ausreicht. Es hat sich bei Versuchen herausgestellt, dass bei einer Leistungsaufnahme während des Aufladens des Energiespeichers von etwa 1 W und einer Leistungsaufnahme im Entkoppelzustand der Schalteinheit von etwa 0 W eine Gesamtleistungsaufnahme im Wartezustand von etwa 1 mW bis 5 mW erreicht werden kann. Dabei hat der Vorgang des Aufladens des Energiespeichers etwa eine Sekunde gedauert, und die im Energiespeicher enthaltene Energie hat für etwa 1000 Sekunden ausgereicht.

Unter einem Haushaltsgerät wird vorliegend ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühl-Gefrier-Kombination oder ein Klimagerät. Das kann aber auch ein Haushaltskleingerät sein, wie beispielsweise ein Kaffeevollautomat oder eine Küchenmaschine.

Die Schalteinheit umfasst einen Halbleiterschalter, über welchen die Spannungsversorgungseinheit mit dem Schaltungseingang gekoppelt werden kann. Die Schalteinheit umfasst außerdem eine Speichereinheit - zum Beispiel einen Kondensator - , über welche ein Steueranschluss des Halbleiterschalters mit dem zweiten Eingangsanschluss des Schaltungseingangs - also mit einem Bezugspotential - gekoppelt ist. Durch Aufladen der Speichereinheit mit elektrischer Energie kann der Halbleiterschalter in seinen elektrisch leitenden Schaltzustand überführt und hierdurch die Schalteinheit in den Koppelzustand geschaltet werden. Die Schalteinheit umfasst darüber hinaus eine mit dem Steueranschluss des Halbleiterschalters gekoppelte Abgriffeinheit, die die Versorgungswechselspannung an dem Schaltungseingang abgreift und eine davon abgeleitete elektrische Spannung an der Speichereinheit bereitstellt. Dadurch kann sich die Schalteinheit also selbsttätig beziehungsweise automatisch in den Koppelzustand überführen. Liegt die Versorgungswechselspannung an dem Schaltungseingang an, so greift die Abgriffeinheit diese Spannung ab und stellt eine davon abgeleitete elektrische Spannung an der Speichereinheit beziehungsweise an dem Steueranschluss des Halbleiterschalters bereit. Überschreitet die Amplitude der an der Speichereinheit anliegenden Spannung einen Schwellwert, so wird der Halbleiterschalter in seinen elektrisch leitenden Schaltzustand überführt und die Schalteinheit entsprechend in den Koppelzustand geschaltet. Der Energiespeicher kann

somit mit elektrischer Energie aufgeladen werden, ohne dass die Steuereinrichtung Steuersignale an die Schalteinheit überhaupt ausgeben muss.

Die Abgriffeinheit kann zum Beispiel einen Spannungsteiler umfassen, welcher die Versorgungswechselspannung an dem Schaltungseingang abgreift und teilt. Die abgegriffene und geteilte Spannung kann an der Schalteinheit beziehungsweise an dem Steueranschluss des Halbleiterschalters bereitgestellt werden, und die Speichereinheit kann mit elektrischer Energie aufgeladen werden. Die Schaltzeit des Halbleiterschalters ist dann abhängig von der Dimensionierung des Spannungsteilers, wie auch der Speichereinheit. Der Spannungsteiler kann zum Beispiel derart ausgebildet sein, dass der Halbleiterschalter nach etwa 1 s nach Anlegen der Versorgungswechselspannung an dem Schaltungseingang in den leitenden Schaltzustand überführt wird. Die von der Versorgungswechselspannung abgeleitete beziehungsweise geteilte Spannung kann zum Beispiel ein Millionstel bis ein Tausendstel der Amplitude der Versorgungswechselspannung betragen.

Der Halbleiterschalter ist bevorzugt mit dem zweiten Eingangsanschluss des Schaltungseingangs beziehungsweise mit dem Bezugspotenzial gekoppelt; mit anderen Worten ist der Halbleiterschalter bevorzugt in den Neutralleiter integriert.

Es kann vorgesehen sein, dass die Steuereinrichtung die Schalteinheit in dem Entkoppelzustand durch Entladen der Speichereinheit halten kann. Zum Beispiel kann die Steuereinrichtung die Speichereinheit periodisch - je nach Auslegung der Abgriffeinheit - entladen. Dann wird vermieden, dass der Halbleiterschalter in seinen elektrisch leitenden Schaltzustand überführt wird, und die Schalteinheit verbleibt in dem Entkoppelzustand. Die Frequenz, mit welcher die Steuereinrichtung das Entladen der Speichereinheit bewirkt, kann an die Schaltzeit des Halbleiterschalters beziehungsweise an die Zeit angepasst werden, in welcher sich die Speichereinheit auflädt und den Halbleiterschalter in den leitenden Schaltzustand überführt. Zum Beispiel kann die Steuereinrichtung die Speichereinheit in Zeitabständen von etwa 500 ms bis 1 s entladen, dann ist gewährleistet, dass der Halbleiterschalter nicht in seinen leitenden Schaltzustand überführt wird und dass die Schalteinheit in dem Entkoppelzustand verbleibt.

Also kann die Steuereinrichtung die Schalteinheit in dem Entkoppelzustand durch Entladen, insbesondere durch periodisches Entladen, der Speichereinheit halten. Um die Schalteinheit in den Koppelzustand zu überführen, kann die Entladung der Speichereinheit ausgesetzt werden. Es ist somit in einer Ausführungsform vorgesehen, dass die Steuereinrichtung dazu ausgelegt ist, die Schalteinheit in den Koppelzustand durch Aussetzen der Entladung der Speichereinheit zu schalten. Wird die Speichereinheit nicht entladen, so steigt die an der Speichereinheit anliegende elektrische Spannung an - die Abgriffeinheit greift die Versorgungswechselspannung an dem Schaltungseingang ab und stellt elektrische Spannung an der Speichereinheit bereit - und der Halbleiterschalter wird in seinen leitenden Schaltzustand geschaltet. Dies erfolgt dann, wenn die an der Speichereinheit anliegende Spannung den Schalt-Schwellwert des Halbleiterschalters überschreitet. Also kann sich die Schalteinheit selbsttätig in den Koppelzustand überführen, nämlich wenn die Steuereinrichtung die Entladung der Speichereinrichtung aussetzt. Zum Überführen der Schalteinheit in den Koppelzustand bedarf es somit keines Eingriffs von Seiten der Steuereinrichtung; die Steuereinrichtung muss lediglich die Entladungsvorgänge der Speichereinheit beenden, um die Schalteinheit in den Koppelzustand zu überführen.

Das Entladen der Speichereinheit kann zum Beispiel so aussehen, dass der Steueranschluss des Halbleiterschalters mit dem zweiten Eingangsanschluss des Schaltungseingangs beziehungsweise mit dem Bezugspotenzial kurzgeschlossen wird. Dabei wird auch die Speichereinheit kurzgeschlossen und somit entladen. Das Kurzschließen der Speichereinheit kann zum Beispiel mit Hilfe eines Schaltelements erfolgen, welches durch die Steuereinrichtung gesteuert werden kann. Ein solches Schaltelement kann zum Beispiel ein Optokoppler sein, welcher auch eine galvanische Trennung zwischen der Steuereinrichtung und der Schalteinheit gewährleistet. Um die Schalteinheit in dem Entkoppelzustand zu halten, muss die Steuereinrichtung lediglich schmale Spannungsimpulse an das Schaltelement ausgeben, nämlich jeweils in vorbestimmten Zeitintervallen. Eine solche Vorgehensweise ist besonders energieeffizient.

Parallel zum Halbleiterschalter kann ein elektrischer Schalter gekoppelt sein, und die Steuereinrichtung kann beim Überführen der Schaltungsanordnung von dem Wartezustand in den Aktivzustand den elektrischen Schalter in seinen elektrisch leitenden Schaltzustand schalten. Dieser elektrische Schalter kann zum Beispiel ein Relais sein, welches durch die Steuereinrichtung angesteuert werden kann. Durch Überbrücken des Halbleiterschalters wird im Aktivzustand gewährleistet, dass größere Leistungen als im Wartezustand durch die Schalteinheit geleitet werden können.

Also wird die Schalteinheit nur während des Vorgangs des Aufladens des Energiespeichers in dem Koppelzustand gehalten, sie wird nach dem Aufladen des Energiespeichers in den Entkoppelzustand überführt. Die Steuereinrichtung kann in dem Wartezustand der Schaltungsanordnung die Schalteinheit so lange in dem Entkoppelzustand halten, bis die Amplitude der Betriebsgleichspannung einen vorbestimmten Grenzwert unterschreitet. Die Schalteinheit wird somit in den Koppelzustand dann überführt, wenn eine vorbestimmte Energiemenge in dem Energiespeicher unterschritten wird. Auf diesem Wege wird erreicht, dass in dem Energiespeicher stets elektrische Energie für die Steuereinrichtung und die Bedieneinrichtung in dem Wartezustand der Schaltungsanordnung zur Verfügung steht.

Wie bereits ausgeführt, kann die Schalteinheit von dem Entkoppelzustand in den Koppelzustand dann überführt werden, wenn die Amplitude der an dem Energiespeicher anliegenden elektrischen Betriebsgleichspannung einen vorbestimmten Grenzwert unterschreitet. Bei der Ausführungsform, in welcher die Schalteinheit sich selbständig in den Koppelzustand überführen kann - nämlich beim Aussetzen der Entladung der Speichereinheit durch die Steuereinrichtung - kann vorgesehen sein, dass die Steuereinrichtung abwartet, bis der Energiespeicher vollständig entladen ist. Wird der Energiespeicher entladen, so wird die Steuereinrichtung aufgrund der fehlenden Spannungsversorgung ausgeschaltet, und sie kann dann die Speichereinheit nicht mehr entladen. So überführt sich die Schalteinheit selbst in den Koppelzustand, und der Energiespeicher wird erneut aufgeladen. Bei dieser Ausführungsform kann auch vorgesehen sein, dass die Steuereinrichtung - und insbesondere ein Mikrocontroller der Steuereinrichtung - bei jedem Aufladevorgang des Energiespeichers eine Zurücksetzung durchläuft. Dann ist sichergestellt, dass die Steuereinrichtung nach jeder Entladung des Energiespeichers wieder ordnungsgemäß in Betrieb genommen wird. Ein Vorteil dieser Ausführungsform besteht darin, dass die Steuereinrichtung "nichts" tun muss, um den Energiespeicher wieder mit elektrischer Energie aufzuladen. Die Steuereinrichtung kann abwarten, bis der Energiespeicher entladen ist, und sich dabei ausschalten lassen. Der Energiespeicher wird wieder aufgeladen, sobald die Schalteinheit sich selbsttätig in den Koppelzustand überführt hat.

Es hat sich jedoch als besonders vorteilhaft herausgestellt, wenn die Steuereinrichtung die Amplitude der Betriebsgleichspannung misst und in dem Wartezustand der Schaltungsanordnung die Schalteinheit dann von dem Entkoppelzustand in den Koppelzustand schaltet, wenn die Betriebsgleichspannung einen vorbestimmten Grenzwert unterschreitet. Bei dieser Ausführungsform erfolgt eine gewollte beziehungsweise bewusste Überführung der Schalteinheit von dem Entkoppelzustand in den Koppelzustand, nämlich mit Hilfe der Steuereinrichtung. Dies kann zum Beispiel so aussehen, dass die Steuereinrichtung beim Unterschreiten des vorbestimmten Grenzwerts durch die Betriebsgleichspannung die Entladung der Speichereinheit in der Schalteinheit aussetzt und somit die Überführung der Schalteinheit in den Koppelzustand veranlasst. Dies hat den Vorteil, dass die Steuereinrichtung - und insbesondere ein Mikrocontroller der Steuereinrichtung - nicht ausgeschaltet beziehungsweise der Betrieb der Steuereinrichtung nicht unterbrochen wird.

Die Schaltungsanordnung kann mit Hilfe der Bedieneinrichtung zwischen dem Aktivzustand und dem Wartezustand (Stand-by-Zustand) überführt werden. Also kann die Schaltungsanordnung nach Betätigen der Bedieneinrichtung durch eine Bedienperson zwischen dem Aktivzustand und dem Wartezustand geschaltet werden. Es hat sich als besonders vorteilhaft herausgestellt, wenn die Bedieneinrichtung einen Annäherungssensor, insbesondere einen kapazitiven Annäherungssensor, umfasst. Ein Eingang des Annäherungssensors kann mit der Spannungsversorgungseinheit gekoppelt sein, ein Ausgang des Annäherungssensors kann mit der Steuereinrichtung gekoppelt sein. Dann kann die Steuereinrichtung ein Ausgangssignal des Annäherungssensors auswerten und abhängig vom Ergebnis dieser Auswertung eine Betätigung des Annäherungssensors durch eine Bedienperson erkennen. Durch Einsatz eines kapazitiven Annäherungssensors wird erreicht, dass die Bedieneinrichtung im Wartezustand relativ wenig Energie verbraucht, die Steuereinrichtung kann den Annäherungssensor zum Beispiel mit einer Abfolge von Spannungsimpulsen beaufschlagen, eine solche Abfolge von Spannungsimpulsen sorgt dann für einen besonders energieeffizienten Betrieb der Schaltungsanordnung im Wartezustand. Ein weiterer Vorteil eines kapazitiven Annäherungssensors ist darin zu sehen, dass ein solcher Sensor besonders benutzerfreundlich ist, eine Bedienperson muss nicht einen mechanischen Schalter betätigen, sie kann lediglich einen Finger an den Annäherungssensors annähern beziehungsweise selbigen Sensor berühren, um das Haushaltsgerät zu aktivieren.

Der Annäherungssensor kann einen Transistor, insbesondere einen PNP-Bipolartransistor, umfassen, dessen Kollektor mit dem Ausgang des Annäherungssensors und hierdurch mit der Steuereinrichtung gekoppelt ist. Der Annäherungssensor kann außerdem einen Kondensator umfassen, dessen Kapazitätswert durch Annäherung veränderbar ist und welcher mit dem Steueranschluss des Transistors gekoppelt ist. Nähert sich eine Bedienperson dem Kondensator, so ändert sich seine Kapazität, was die Steuereinrichtung anhand des Ausgangssignals erkennen kann. Der Steueranschluss und der Emitter des Transistors können mit dem Eingang des Annäherungssensors und hierdurch mit der Spannungsversorgungseinheit gekoppelt sein, nämlich beispielsweise über jeweils einen ohmschen Widerstand. Ein solcher Aufbau des Annäherungssensors sorgt dafür, dass die Steuereinrichtung die Betätigung des Annäherungssensors durch eine Bedienperson besonders einfach erkennen kann, nämlich anhand der Amplitude des Ausgangssignals. Ein Annäherungssensor, dessen Betätigung anhand der Amplitude des Ausgangssignals erkannt werden kann, ist bereits aus dem Dokument DE 10 2005 041 113 A1 bekannt. Dort wird an den Annäherungssensor ein Taktsignal ausgegeben, dessen Frequenz in einem Wertebereich von 10 bis 100 kHz liegt. Am Ausgang des Annäherungssensors steht dann ein Gleichspannungssignal für die Auswertung zur Verfügung. Eine besondere Herausforderung besteht darin, diese Lösung gemäß Druckschrift DE 10 2005 041 113 A1 dahingehend zu verbessern, dass weniger Energie bei der Auswertung des Ausgangssignals verbraucht wird.

Es ist deshalb in einer Ausführungsform vorgesehen, dass die Steuereinrichtung in vorbestimmten Zeitabständen jeweils ein Beaufschlagen des Annäherungssensors mit einer vorbestimmten Anzahl von Spannungsimpulsen - zum Beispiel mit 2 oder 3 Spannungsimpulsen - aus dem Energiespeicher veranlasst, um anhand des Ausgangssignals des Annäherungssensors zu erkennen, ob eine Bedienperson den Annäherungssensor betätigt oder nicht. Zum Beispiel kann die Steuereinrichtung alle 10 ms bis 100 ms den Annäherungssensor jeweils mit zumindest zwei Spannungsimpulsen beaufschlagen. Die Zeitdauer eines einzelnen Spannungsimpulses liegt bevorzugt in einem Wertebereich von 10 $\mu$s bis 50 $\mu$s; der zeitliche Abstand zwischen zwei nacheinander folgenden Spannungsimpulsen liegt bevorzugt in einem Wertebereich von 60 $\mu$s bis 100 $\mu$s. Also kann der Annäherungssensor im Gegensatz zum Gegenstand gemäß Druckschrift DE 10 2005 041 113 A1 - dort wird der Annäherungssensor mit einem Taktsignal mit einer Frequenz von 10 kHz bis 100 kHz beaufschlagt - mit jeweils wenigen Spannungsimpulsen in vorbestimmten Zeitabständen, zum Beispiel alle 100 ms, beaufschlagt werden. Werden zum Beispiel nur drei Spannungsimpulse innerhalb einer Zeit von 100 ms an den Annäherungssensor abgegeben, so ist die Leistungsaufnahme des Annäherungssensors im Wartezustand der Schaltungsanordnung entsprechend sehr gering. Auf diesem Wege gelingt es, dass die im Energiespeicher enthaltene Energie für eine relativ lange Zeit ausreicht und die Schalteinheit entsprechend lange in dem Entkoppelzustand verbleiben kann.

Zum Zwecke der Beaufschlagung des Annäherungssensors mit Spannungsimpulsen kann die Schaltungsanordnung eine Pulserzeugungseinheit umfassen. Eine solche Pulserzeugungseinheit kann zwischen der Spannungsversorgungseinheit und dem Annäherungssensor gekoppelt sein und einen Steueranschluss aufweisen, der mit der Steuereinrichtung gekoppelt ist. Unter Ausgabe entsprechender Steuersignale an die Pulserzeugungseinheit kann die Steuereinrichtung dann den Annäherungssensor mit einer Abfolge von Spannungsimpulsen aus dem Energiespeicher beaufschlagen. Die Pulserzeugungseinheit kann einen elektrischen Schalter umfassen, nämlich insbesondere einen Halbleiterschalter. Dann können die Spannungsimpulse ohne viel Aufwand, nämlich durch einfaches Schalten des elektrischen Schalters durch die Steuereinrichtung erzeugt werden.

Werden an den Annäherungssensor nur wenige Impulse innerhalb eines vorbestimmten Zeitintervalls abgegeben, so beinhaltet das Ausgangssignal des Annäherungssensors ebenfalls Spannungsimpulse, deren Höhe davon abhängt, ob eine Bedienperson den Annäherungssensor betätigt oder nicht. Es gilt dabei die Beziehung, dass die Amplitude der Spannungsimpulse des Ausgangssignals des Annäherungssensors dann höher ist, wenn eine Bedienperson den Annäherungssensor betätigt. Es kann somit anhand der Auswertung der Amplitude der Spannungsimpulse des Ausgangssignals erkannt werden, ob eine Bedienperson den Annäherungssensor betätigt oder nicht beziehungsweise ob die Schaltungsanordnung zwischen dem Wartezustand und dem Aktivzustand überführt werden soll oder nicht.

Die Auswertung des Ausgangssignals kann zum Beispiel so aussehen, dass die Steuereinrichtung die Amplitude des Ausgangssignals mit einem Referenzsignal vergleicht und abhängig von dem Vergleich erkennt, ob eine Bedienperson den Annäherungssensor betätigt oder nicht. Da die Amplitude des Referenzsignals in der Steuereinrichtung bekannt ist, kann auch die absolute Amplitude des Ausgangssignals des Annäherungssensors durch die Steuereinrichtung ermittelt werden.

Die Steuereinrichtung kann überprüfen, ob die Amplitude eines Spannungsimpulses des Ausgangssignals des Annäherungssensors innerhalb eines bestimmten Wertebereichs liegt. Liegt diese Amplitude innerhalb des bestimmten Wertebereichs, so kann die Steuereinrichtung bestätigen, dass eine Bedienperson den Annäherungssensor betätigt. Liegt die Amplitude des Spannungsimpulses unterhalb des Wertebereichs, so liegt keine Betätigung des Annäherungssensors vor. Überschreitet hingegen die Amplitude des Spannungsimpulses den bestimmten Wertebereich, so liegt ein Fehlerfall vor, und die Steuereinrichtung berücksichtigt in einem solchen Fall den Spannungsimpuls nicht. Die Schaltungsanordnung wird also nur dann von dem Wartezustand in den Aktivzustand überführt, wenn die Amplitude des Spannungsimpulses des Ausgangssignals innerhalb des bestimmten Wertebereichs liegt.

Die Amplitude der Spannungsimpulse des vom Annäherungssensor ausgegebenen Ausgangssignals ist jedoch nicht nur davon abhängig, ob eine Bedienperson den Annäherungssensor betätigt oder nicht. Diese Amplitude wird außerdem durch weitere Einflussgrößen beeinflusst; die Amplitude der Spannungsimpulse wird zum Beispiel durch die Amplitude der am Energiespeicher anliegenden Betriebsgleichspannung bestimmt, mit welcher der Annäherungssensor pulsweise beaufschlagt wird. Darüber hinaus beeinflussen die Amplitude der vom Annäherungssensor ausgegebenen Spannungsimpulse weitere Störgrößen, wie insbesondere die Temperatur und andere umgebungsbedingte Störgrößen. Um all diese Beeinflussungen der Amplitude des Ausgangssignals des Annäherungssensors bei der Auswertung des Ausgangssignals zu berücksichtigen, ist in einer Ausführungsform vorgesehen, dass die Steuereinrichtung den Wertebereich an die Amplitude des Ausgangssignals anpasst. Und zwar kann die Steuereinrichtung nach Empfang eines Spannungsimpulses des Ausgangssignals des Annäherungssensors den Wertebereich für die Auswertung nachfolgender Spannungsimpulse abhängig von der Amplitude des empfangenen Spannungsimpulses erneut bestimmen. Dann ist gewährleistet, dass etwaige Störgrößen die Auswertung des Ausgangssignals des Annäherungssensors nicht verfälschen können.

Wird die Versorgungswechselspannung an den Schaltungseingang zum ersten Mal angelegt beziehungsweise wird die Schaltungsanordnung mit einem elektrischen Versorgungsnetz gekoppelt, so wird der Wertebereich durch die Steuereinrichtung erstmals bestimmt. Dies kann derart erfolgen, dass die Steuereinrichtung den Annäherungssensor mit einer Abfolge von Spannungsimpulsen beaufschlagt und die Amplitude der Spannungsimpulse des Ausgangssignals des Annäherungssensors misst. Der untere Grenzwert des Wertebereichs wird zunächst so bestimmt, dass er etwas größer als die Amplitude der empfangenen Spannungsimpulse ist. Der obere Grenzwert des Wertebereichs kann bezüglich des unteren Grenzwerts in der Steuereinrichtung vordefiniert werden. Wird also der untere Grenzwert des Wertebereichs bestimmt, so ergibt sich daraus automatisch der obere Grenzwert, so dass der gesamte Wertebereich durch Bestimmen lediglich des unteren Grenzwertes bestimmt werden kann.

Ist der Wertebereich erstmals bestimmt - nämlich nach Inbetriebnahme der Schaltungsanordnung - so kann die Steuereinrichtung mit der Überwachung des Annäherungssensors beginnen, indem sie zum Beispiel - wie oben ausgeführt - den Annäherungssensor in vorbestimmten Zeitabständen jeweils mit einer vorbestimmten Anzahl von Spannungsimpulsen aus dem Energiespeicher beaufschlagt. Zu jedem Spannungsimpuls, mit welchem der Annäherungssensor beaufschlagt wird, ergibt sich ein Spannungsimpuls in dem Ausgangssignal des Annäherungssensors. Die Steuereinrichtung überprüft, ob die Amplitude des Spannungsimpulses des Ausgangssignals innerhalb des bestimmten Wertebereichs liegt oder nicht. Wird dies durch die Steuereinrichtung bestätigt, so wird die Schaltungsanordnung in den Aktivzustand überführt. Ist die Amplitude des empfangenen Spannungsimpulses des Ausgangssignals geringer als der bestimmte Wertebereich, so liegt keine Betätigung des Annäherungssensors vor. In jedem Fall bestimmt die Steuereinrichtung den Wertebereich erneut, nämlich abhängig von der Amplitude des empfangenen Spannungsimpulses des Ausgangssignals. Eine solche Anpassung des Wertebereichs kann zum Beispiel so aussehen, dass eine Differenz aus dem momentanen unteren Grenzwert des Wertebereichs und der Amplitude des aktuell empfangenen Spannungsimpulses mit einem Faktor kleiner eins multipliziert wird und das Ergebnis dieser Multiplizierung dem aktuellen unteren Grenzwert des Wertebereichs aufaddiert wird. Dann ergibt sich ein neuer unterer Grenzwert des Wertebereichs, und der Wertebereich wird erneut bestimmt, nämlich für die Auswertung nachfolgender Spannungsimpulse.

Wie bereits ausgeführt, werden die Steuereinrichtung und die Bedieneinrichtung mit elektrischer Energie aus dem Energiespeicher der Spannungsversorgungseinheit versorgt. Bevorzugt stellt die Spannungsversorgungseinheit zwei unterschiedliche Gleichspannungen bereit, nämlich einerseits für die Bedieneinrichtung und andererseits für die Steuereinrichtung. Für die Bedieneinrichtung kann die Spannungsversorgungseinheit zum Beispiel eine Spannung von 5 V und für die Steuereinrichtung eine Spannung von 3,3 V erzeugen. Die an dem Energiespeicher anliegende Betriebsgleichspannung kann zum Beispiel 9 V betragen, und die Spannungsversorgungseinheit kann zwei lineare Spannungsregler umfassen, die zum Bereitstellen der Spannungen von 5 V beziehungsweise 3,3 V ausgebildet sind. Diese Spannungsregler sind bevorzugt solche, die zum extrem geringen Leistungsverbrauch ausgelegt sind (Low Power Voltage Regulator). Diese Ausführungsform sorgt für einen energieeffizienten Betrieb der Schaltungsanordnung in dem Wartezustand.

Die Erfindung umfasst außerdem ein Haushaltsgerät mit einer erfindungsgemäßen Schaltungsanordnung oder einer bevorzugten Ausgestaltung derselben. Die mit Bezug auf die Schaltungsanordnung vorgestellten bevorzugten Ausführungsformen und deren Vorteile gelten entsprechend für das erfindungsgemäße Haushaltsgerät.

Ein erfindungsgemäßes Verfahren ist zum Betreiben einer Schaltungsanordnung in einem Haushaltsgerät ausgelegt, die zwischen einem Wartezustand und einem Aktivzustand überführbar ist. Es wird eine Versorgungswechselspannung an einen Schaltungseingang der Schaltungsanordnung angelegt. Eine Schalteinheit wird von einem Entkoppelzustand, in welchem eine Spannungsversorgungseinheit von dem Schaltungseingang entkoppelt ist, in einen Koppelzustand, in welchem die Spannungsversorgungseinheit mit dem Schaltungseingang elektrisch gekoppelt ist, geschaltet. Die Spannungsversorgungseinheit stellt eine Betriebsgleichspannung aus der Versorgungswechselspannung bereit, und ein Energiespeicher wird hierdurch mit elektrischer Energie aufgeladen, wobei an dem Energiespeicher die Betriebsgleichspannung anliegt. Nach dem Aufladen des Energiespeichers wird die Schalteinheit in den Entkoppelzustand überführt.

Des Weiteren wird durch eine mit einem Steueranschluss eines Halbleiterschalters gekoppelte Abgriffeinheit die Versorgungswechselspannung an dem Schaltungseingang abgegriffen und eine daraus abgeleitete elektrischen Spannung an einer Speichereinheit, über welche der Steueranschluss des Halbleiterschalters mit einem zweiten Eingangsanschluss des Schaltungseingangs gekoppelt ist, bereitgestellt. Der Halbleiterschalter wird überführt in seinen elektrisch leitenden Schaltzustand durch Aufladen der Speichereinheit mit elektrischer Energie, wodurch die Spannungsversorgungseinheit mit dem Schaltungseingang über den Halbleiterschalter gekoppelt wird.

Die mit Bezug auf die erfindungsgemäße Schaltungsanordnung vorgestellten bevorzugten Ausführungsformen und deren Vorteile geltend entsprechend für das erfindungsgemäße Verfahren.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar.

Die Erfindung wird anhand einzelner bevorzugter Ausführungsbeispiele sowie unter Bezugnahme auf die beigefügten Zeichnungen näher erläutert. Es zeigen:

Fig. 1 in schematischer Darstellung ein Haushaltsgerät mit einer Schaltungsanordnung gemäß einer Ausführungsform der Erfindung;

Fig. 2 in schematischer und detaillierter Darstellung die Schaltungsanordnung gemäß Fig. 1;

Fig. 3 in schematischer Darstellung eine Schalteinheit der Schaltungsanordnung;

Fig. 4 in schematischer Darstellung einen Abschnitt einer Spannungsversorgungseinheit der Schaltungsanordnung;

Fig. 5 in schematischer Darstellung eine Zurücksetzungseinheit der Schaltungsanordnung;

Fig. 6 in schematischer Darstellung eine Pulserzeugungseinheit der Schaltungsanordnung;

Fig. 7 in schematischer Darstellung einen Annäherungssensor einer Bedieneinrichtung der Schaltungsanordnung;

Fig. 8 in schematischer Darstellung einen Mikrocontroller und einen Digital-Analog-Wandler einer Steuereinrichtung der Schaltungsanordnung; und

Fig. 9a bis 9e zeitliche Verläufe von an den Annäherungssensor abgegebenen Spannungsimpulsen sowie von dem Annäherungssensor ausgegebenen Spannungsimpulsen, wobei anhand der Verläufe ein Auswerteverfahren näher erläutert wird.

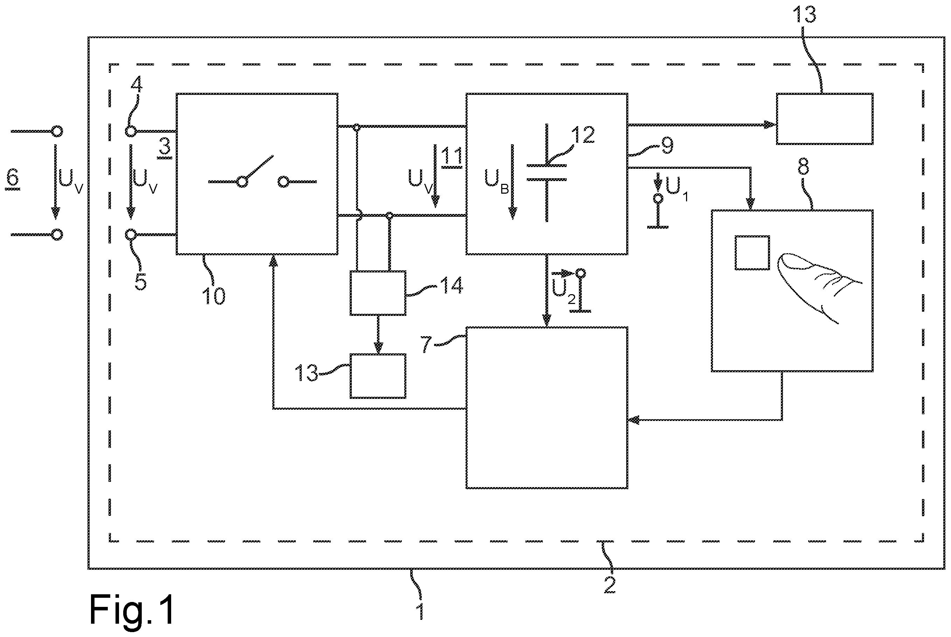

Fig. 1 zeigt ein Haushaltsgerät 1 mit einer Schaltungsanordnung 2 gemäß einer Ausführungsform der Erfindung. Die Schaltungsanordnung 2 dient zum Betreiben des Haushaltsgeräts 1. Die Schaltungsanordnung 1 umfasst einen Schaltungseingang 3 mit einem ersten und einem zweiten Eingangsanschluss 4, 5. Über die Eingangsanschlüsse 4, 5 kann die Schaltungsanordnung 2 mit einem elektrischen Versorgungsnetz 6 gekoppelt werden, dann liegt zwischen den Eingangsanschlüssen 4, 5 eine Versorgungswechselspannung $U_V$ des Versorgungsnetzes 6 an.

Die Schaltungsanordnung 2 umfasst auch eine Steuereinrichtung 7, eine mit der Steuereinrichtung 7 gekoppelte Bedieneinrichtung 8, eine Spannungsversorgungseinheit 9 sowie eine zwischen dem Schaltungseingang 3 und der Spannungsversorgungseinheit 9 geschaltete Schalteinheit 10. Über die Schalteinheit 10 kann die Spannungsversorgungseinheit 9 mit dem Schaltungseingang 3 und somit mit der Versorgungswechselspannung $U_V$ gekoppelt werden. Dabei kann die Schalteinheit 10 zwischen einem Koppelzustand, in welchem die Spannungsversorgungseinheit 9 mit dem Schaltungseingang 3 elektrisch gekoppelt ist, und einem Entkoppelzustand, in welchem die Spannungsversorgungseinheit 9 von dem Schaltungseingang 3 entkoppelt ist, geschaltet werden. Befindet sich die Schalteinheit 10 in dem Koppelzustand, so liegt an einem Eingang 11 der Spannungsversorgungseinheit 9 die Versorgungswechselspannung $U_V$ an. Aus der Versorgungswechselspannung $U_V$ erzeugt die Spannungsversorgungseinheit 9 eine Betriebsgleichspannung $U_B$, welche an einem in Fig. 1 schematisch dargestellten Energiespeicher 12 anliegt. Wird die Betriebsgleichspannung $U_B$ von der Spannungsversorgungseinheit 9 bereitgestellt, so wird der Energiespeicher 12, welcher im Ausführungsbeispiel als Kondensator ausgebildet ist, mit elektrischer Energie aufgeladen. Die Betriebsgleichspannung $U_B$ beträgt im Ausführungsbeispiel 9 V.

Die Steuereinrichtung 7 und die Bedieneinrichtung 8 werden mit elektrischer Energie aus dem Energiespeicher 12 versorgt. Zu diesem Zwecke erzeugt die Spannungsversorgungseinheit 9 zwei Gleichspannungen, nämlich einerseits eine erste Gleichspannung $U_1$ für die Bedieneinrichtung 8 sowie eine zweite Gleichspannung $U_2$ für die Steuereinrichtung 7. Die erste und die zweite Gleichspannung $U_1$, $U_2$ betragen im Ausführungsbeispiel 5 V respektive 3,3 V.

Mittels der Bedieneinrichtung 8 kann die Schaltungsanordnung 2 zwischen einem Aktivzustand und einem Wartezustand (Stand-by-Zustand) überführt werden. Im Aktivzustand wird elektrische Energie für elektrische Verbraucher 13 des Haushaltsgeräts 1 bereitgestellt. Diese Energie kann durch die Spannungsversorgungseinheit 9 bereitgestellt werden und/oder sie kann durch ein separates Netzteil 14 erzeugt werden, welches mit der Schalteinheit 10 gekoppelt ist. In jedem Fall ist es die Schalteinheit 10, die direkt mit dem Schaltungseingang 3 verbunden ist. Somit ist sichergestellt, dass die Schaltungsanordnung 2 gar keine Leistung von dem Versorgungsnetz 6 aufnimmt, wenn sich die Schalteinheit 10 in dem Entkoppelzustand befindet.

Die Steuereinrichtung 7 kann eine zentrale Steuereinrichtung des Haushaltsgeräts 1 sein. Alternativ kann die Steuereinrichtung 7 eine lokale beziehungsweise separate Steuereinrichtung der Schaltungsanordnung 2 sein, dann ist im Haushaltsgerät 1 eine weitere, zentrale Steuereinrichtung vorgesehen. Im Ausführungsbeispiel stellt die Steuereinrichtung 7 eine separate, lokale Steuereinrichtung der Schaltungsanordnung 2 dar - die Steuereinrichtung 7 dient also zum Überwachen der Bedieneinrichtung 8 und zum Überführen der Schaltungsanordnung 2 zwischen dem Aktivzustand und dem Wartezustand. Im Wartezustand wird keine elektrische Energie für die elektrischen Verbraucher 13 erzeugt. Im Wartezustand wird die elektrische Energie aus dem Energiespeicher 12 lediglich durch die Bedieneinrichtung 8, die Steuereinrichtung 7 und gegebenenfalls durch die Spannungsversorgungseinheit 9 selbst verbraucht.

Nachfolgend wird die grundsätzliche Funktion der in Fig. 1 dargestellten Schaltungsanordnung 2 näher beschrieben. Liegt die Versorgungswechselspannung $U_V$ am Schaltungseingang 3 an, so wird die Schalteinheit 10 in den Koppelzustand überführt. Dann liegt die Versorgungswechselspannung $U_V$ auch am Eingang 11 der Spannungsversorgungseinheit 9. Die Spannungsversorgungseinheit 9 erzeugt aus der Versorgungswechselspannung $U_V$ die Betriebsgleichspannung $U_B$, und der Energiespeicher 12 wird aufgeladen. Nach dem Aufladen des Energiespeichers 12 überführt die Steuereinrichtung 7 die Schalteinheit 10 in den Entkoppelzustand, und die Schaltungsanordnung 2 wird vom Versorgungsnetz 6 entkoppelt. Ein solcher Vorgang des Aufladens des Energiespeichers 12 dauert vorzugsweise eine Sekunde. Dann reicht die im Energiespeicher 12 enthaltene elektrische Energie für etwa 1000 Sekunden, während den 1000 Sekunden ist die Schaltungsanordnung 2 vom Versorgungsnetz 6 entkoppelt und verbraucht keine Energie vom Versorgungsnetz 6.

Die Steuereinrichtung 7 erfasst die Betriebsgleichspannung $U_B$ und somit die Energie im Energiespeicher 12. Dabei kann die Steuereinrichtung 7 zum Beispiel die zweite Gleichspannung $U_2$ messen und abhängig von der Amplitude der zweiten Gleichspannung $U_2$ auf die Amplitude der Betriebsgleichspannung $U_B$ zurückschließen. Unterschreitet die Amplitude der zweiten Gleichspannung $U_2$ beziehungsweise die der Betriebsgleichspannung $U_B$ einen vorbestimmten Grenzwert (zum Beispiel 1 V bei der zweiten Gleichspannung $U_2$), so ermöglicht die Steuereinrichtung 7, dass die Schalteinheit 10 in den Koppelzustand überführt wird und der Energiespeicher 12 wieder aufgeladen wird. Danach wird die Schalteinheit 10 wieder in den Entkoppelzustand überführt.

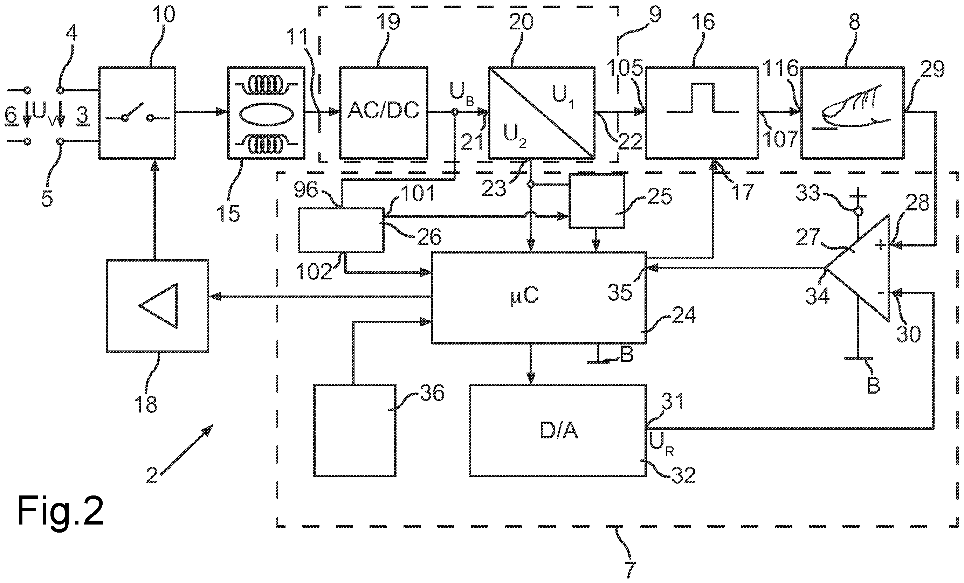

Fig. 2 zeigt ein detailliertes Blockschaltbild der Schaltungsanordnung 2. Zwischen der Schalteinheit 10 und der Spannungsversorgungseinheit 9 ist ein Netzfilter 15 (EMV-Filter) gekoppelt. Dieser Netzfilter 15 hat die Aufgabe, Störsignale von der Schaltungsanordnung 2 sowie von dem Versorgungsnetz 6 auszufiltern. Zwischen der Spannungsversorgungseinheit 9 und der Bedieneinrichtung 8 ist eine Pulserzeugungseinheit 16 geschaltet, die einen Steueranschluss 17 aufweist, der mit der Steuereinrichtung 7 gekoppelt ist. Über den Steueranschluss 17 kann die Steuereinrichtung die Pulserzeugungseinheit 16 ansteuern, unter Ausgabe entsprechender Steuersignale an die Pulserzeugungseinheit 16 kann die Steuereinrichtung 7 ein Beaufschlagen der Bedieneinrichtung 8 mit Spannungsimpulsen veranlassen. Diese Spannungsimpulse haben dann dieselbe Amplitude, wie die Gleichspannung $U_1$.

Die Steuereinrichtung 7 ist über einen Treiber 18 mit der Schalteinheit 10 gekoppelt. Somit kann die Steuereinrichtung 7 über den Treiber 18 die Schalteinheit 10 ansteuern, nämlich zwischen dem Koppelzustand und dem Entkoppelzustand überführen.

Die Spannungsversorgungseinheit 9 umfasst ein Netzteil 19 sowie einen Gleichspannungswandler 20. Das Netzteil 19 erzeugt dabei die Betriebsgleichspannung $U_B$ aus der Versorgungswechselspannung $U_V$. Die Betriebsgleichspannung $U_B$ wird an einem Eingang 21 des Gleichspannungswandlers 20 bereitgestellt. Aus der Betriebsgleichspannung $U_B$ erzeugt der Gleichspannungswandler 20 die erste und die zweite Gleichspannung $U_1$, $U_2$, nämlich entsprechend an einem ersten Ausgang 22 beziehungsweise einem zweiten Ausgang 23. Der erste Ausgang 22 ist dabei mit der Pulserzeugungseinheit 16 gekoppelt, und der zweite Ausgang 23 ist mit der Steuereinrichtung 7 gekoppelt.

Die Steuereinrichtung 7 umfasst einen Mikrocontroller 24, der zum extrem geringen Stromverbrauch ausgelegt ist. Der Mikrocontroller 24 kann zwischen einem Wachzustand (Normal Operation Mode) und einem Schlafzustand (Power Down Mode) geschaltet werden. Der Mikrocontroller 24 wird aus dem Schlafzustand in den Wachzustand mit Hilfe eines Zeitweckers 25 (Timer) überführt. Der Zeitwecker 25 kann auch in den Mikrocontroller 24 integriert werden. Sowohl der Mikrocontroller 24 als auch der Zeitwecker 25 werden mit der zweiten Gleichspannung $U_2$ versorgt.

Die Steuereinrichtung 7 umfasst außerdem eine Zurücksetzungseinheit 26 (reset), die am Ausgang des Netzteils 19 die Betriebsgleichspannung $U_B$ abgreift. Die Zurücksetzungseinheit 26 ist mit dem Zeitwecker 25 und dem Mikrocontroller 24 gekoppelt und kann den Zeitwecker 25 und den Mikrocontroller 24 zurücksetzen. (reset).

Diese Zurücksetzung erfolgt durch Ausgabe eines Spannungsimpulses an den Zeitwecker 25 und den Mikrocontroller 24. Ein solcher Spannungsimpuls wird dann erzeugt, wenn die Betriebsgleichspannung $U_B$ an dem Energiespeicher 12 ansteigt beziehungsweise wenn der Energiespeicher 12 mit Energie aufgeladen wird. Also durchlaufen der Mikrocontroller 24 und der Zeitwecker 25 die Zurücksetzung nach jedem Aufladen des Energiespeichers 12.

Die Steuereinrichtung 7 umfasst außerdem einen analogen Komparator 27, dessen positiver Eingang 28 mit einem Ausgang 29 der Bedieneinrichtung 8 gekoppelt ist und dessen negativer Eingang 30 mit einem Ausgang 31 eines Digital-Analog-Wandlers 32 gekoppelt ist. Der Komparator 27 kann auch im Mikrocontroller 24 integriert sein. Ein Versorgungsanschluss 33 des Komparators 27 ist mit einer Spannungsquelle gekoppelt, nämlich zum Beispiel mit der ersten oder der zweiten Gleichspannung $U_1$ beziehungsweise $U_2$. Darüber hinaus ist der Komparator 27 mit einem Bezugspotential B der Steuereinrichtung 7 gekoppelt. Mit seinem Ausgang 34 ist der Komparator 27 mit einem Eingang 35 des Mikrocontrollers 24 gekoppelt.

Die Steuereinrichtung 7 weist ferner einen nicht-flüchtigen Speicher 36 auf, der mit dem Mikrocontroller 24 gekoppelt ist. Die in einem solchen Speicher 36 gespeicherten Informationen bleiben erhalten, nämlich auch dann, wenn die Steuereinrichtung 7 beziehungsweise die Schaltungsanordnung 2 ausgeschaltet ist.

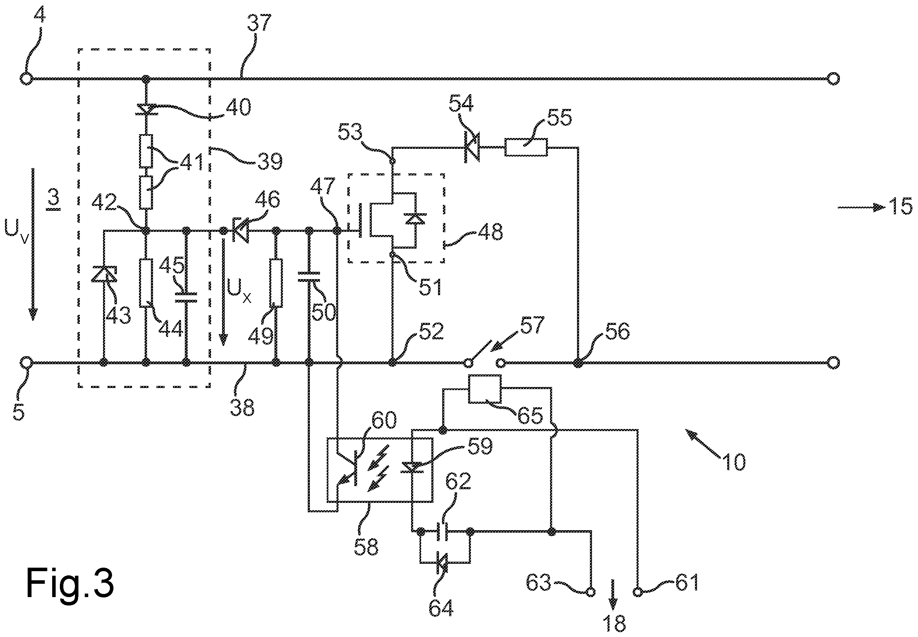

Fig. 3 zeigt in schematischer Darstellung den Aufbau der Schalteinheit 10. Wie bereits ausgeführt, ist die Schalteinheit 10 direkt mit dem Schaltungseingang 3 verbunden, so dass der Schaltungseingang 3 der Schaltungsanordnung 2 auch den Eingang der Schalteinheit 10 darstellt. An dem zweiten Eingangsanschluss 5 ist ein Bezugspotential bereitgestellt, der erste Eingangsanschluss 4 ist mit einem Phasenleiter 37 gekoppelt. Der zweite Eingangsanschluss 5 ist mit einem Neutralleiter 38 gekoppelt. Die Schalteinheit 10 umfasst eine Abgriffeinheit 39, die an dem Schaltungseingang 3 die Versorgungswechselspannung $U_V$ abgreift. Die Abgriffeinheit 39 umfasst einen Spannungsteiler, der eine Diode 40, ohmsche Widerstände 41, einen Spannungsteilerpol 42 sowie eine Parallelschaltung aus einer Zenerdiode 43, einem ohmschen Widerstand 44 und einem Kondensator 45 aufweist. Die Anode der Diode 40 ist mit dem Phasenleiter 37 gekoppelt, die Kathode der Diode 40 ist über die ohmschen Widerstände 41 mit dem Spannungsteilerpol 42 gekoppelt. Die ohmschen Widerstände 41 ergeben insgesamt einen Widerstandswert aus einem Wertebereich von 0,5 MΩ bis 5 MΩ. Die Kathode der Zenerdiode 43 ist mit dem Spannungsteilerpol 42 gekoppelt, und die Anode der Zenerdiode 43 ist mit dem Neutralleiter 38 gekoppelt. Parallel zur Zenerdiode 43 sind der Widerstand 44 und der Kondensator 45 geschaltet. Also greift die Abgriffeinheit 39 die Versorgungswechselspannung $U_V$ ab und stellt an dem Spannungsteilerpol eine davon abgeleitete Spannung $U_X$, die betragsmäßig deutlich geringer als die Versorgungswechselspannung $U_V$ ist.

Der Spannungsteilerpol 42 ist über eine Zenerdiode 46 mit einem Steueranschluss 47 eines Halbleiterschalters 48 gekoppelt, der im Ausführungsbeispiel als MOSFET ausgebildet ist. Dabei ist die Anode der Zenerdiode 46 mit dem Steueranschluss 47 verbunden, und die Kathode der Zenerdiode 46 ist mit dem Spannungsteilerpol 42 verbunden. Die Zenerdiode 43 dient zum Schutz des Halbleiterschalters 48 vor Überspannung.

Zwischen dem Steueranschluss 47 und dem Neutralleiter 38 ist eine Parallelschaltung aus einem ohmschen Widerstand 49 und einer Speichereinheit 50 geschaltet, die im Ausführungsbeispiel ein Kondensator ist.

Der Emitter 51 (Source) des Halbleiterschalters 48 ist mit einem ersten Pol 52 des Neutralleiters 38 verbunden, und der Kollektor 53 (Drain) des Halbleiterschalters 48 ist über eine Diode 54 und einen ohmschen Widerstand 55 mit einem zweiten Pol 56 des Neutralleiters 38 gekoppelt. Der erste Pol 52 kann über ein Relais 57 mit dem zweiten Pol 56 gekoppelt beziehungsweise von diesem entkoppelt werden. Also ist der Halbleiterschalter 48 in den Schaltungszweig des Neutralleiters 38 integriert. Befindet sich der Halbleiterschalter 48 im elektrisch leitenden Schaltzustand und das Relais 57 im elektrisch sperrenden Schaltzustand, so lässt der Halbleiterschalter 48 nur die positiven Halbwellen der Versorgungswechselspannung $U_V$ über die Schalteinheit 10 durch. Die negativen Halbwellen der Versorgungswechselspannung $U_V$ werden nämlich mit Hilfe der Dioden 54 gesperrt. Der Widerstand 55 dient zur Strombegrenzung im Stromkreis des Halbleiterschalters 48.

Die Schalteinheit 10 umfasst außerdem einen Optokoppler 58, welcher eine Leuchtdiode 59 sowie einen Fototransistor 60 aufweist. Dabei ist der Fototransistor 60 einerseits mit dem Steueranschluss 47 des Halbleiterschalters 48 und andererseits mit dem Neutralleiter 38 und somit mit dem Bezugspotential 5 gekoppelt. Die Anode der Leuchtdiode 59 ist mit einem Anschluss 61 gekoppelt, und die Kathode der Leuchtdiode 59 ist über einen Kondensator 62 mit einem Anschluss 63 gekoppelt. Die Anschlüsse 61 und 63 sind dann über den Treiber 18 mit der Steuereinrichtung 7 gekoppelt (siehe Fig. 2). Parallel zum Kondensator 62 ist eine Diode 64 geschaltet. Mit den Anschlüssen 61, 63 ist darüber hinaus ein Steuerelement 65 (zum Beispiel eine Spule) für das Relais 57 gekoppelt. Durch Einsatz des Optokopplers 58 gelingt es, eine galvanische Entkopplung zwischen dem Bezugspotential 5 der Schalteinheit 10 und dem Bezugspotential B der Steuereinrichtung 7 aufrechtzuerhalten.

Fließt über das Steuerelement 65 Strom - bewirkt durch entsprechende Ansteuerung von Seiten der Steuereinrichtung 7 - so ist das Relais 57 geschlossen. Fließt über das Steuerelement 65 kein Strom, so ist das Relais 57 offen.

Nachfolgend wird die Funktionsweise der in Fig. 3 dargestellten Schalteinheit 10 näher erläutert. Zunächst wird die Versorgungswechselspannung $U_V$ an den Schaltungseingang 3 angelegt, nämlich etwa durch Koppeln eines mit dem Schaltungseingang 3 verbundenen Steckers mit einer Steckdose. Zu diesem Zeitpunkt befindet sich der Halbleiterschalter 48 noch im sperrenden Schaltzustand, wie auch das Relais 57. Die Speichereinheit 50 ist entladen. Die Abgriffeinheit 39 greift die Versorgungswechselspannung $U_V$ ab und stellt die Spannung $U_X$ zwischen dem Spannungsteilerpol 42 und dem Neutralleiter 38 bereit. Mit dieser Spannung $U_X$ wird die Speichereinheit 50 langsam aufgeladen. Der Vorgang des Aufladens der Speichereinheit 50 kann zum Beispiel 1 s dauern. Überschreitet die an der Speichereinheit 50 anliegende Spannung $U_X$ eine Schaltschwelle des Halbleiterschalters 48, so wird der Halbleiterschalter 48 in seinen elektrisch leitenden Schaltzustand überführt, ohne dass die Steuereinrichtung 7 Steuersignale an die Schalteinheit 10 sendet. Dann lässt die Schalteinheit 10 aufgrund der Anordnung der Diode 54 lediglich die positiven Halbwellen der Versorgungswechselspannung $U_V$ durch. Die negativen Halbwellen der Versorgungswechselspannung $U_V$ werden durch die Diode 55 gesperrt. Ist der Halbleiterschalter 48 leitend, so befindet sich die Schalteinheit 10 in dem Koppelzustand, in welchem die Spannungsversorgungseinheit 9 (Fig. 2) mit dem Schaltungseingang 3 elektrisch gekoppelt ist. Also kann sich die Schalteinheit 10 nach Anlegen der Versorgungswechselspannung $U_V$ an den Schaltungseingang 3 selbsttätig in den Koppelzustand überführen, nämlich ohne Hilfe von Seiten der Steuereinrichtung 7. Wird zwischen den Anschlüssen 61, 63 durch die Steuereinrichtung 7 eine elektrische Spannung angelegt, so wird die Leuchtdiode 59 mit einem Spannungsimpuls - aufgrund des Kondensators 62 - beaufschlagt. Dann wird der Fototransistor 60 angesteuert, und der Steueranschluss 47 des Halbleiterschalters 48 wird gegen das Bezugspotenzial 5 beziehungsweise gegen den Neutralleiter 38 kurzgeschlossen. Durch Anlegen einer elektrischen Spannung zwischen die Anschlüsse 61, 63 kann die Steuereinrichtung 7 somit die Speichereinheit 50 entladen und so die Schalteinheit 10 von dem Koppelzustand in den Entkoppelzustand überführen. Durch periodisches Entladen der Speichereinheit 50 kann die Steuereinrichtung 7 die Schalteinheit 10 in dem Entkoppelzustand halten.

Wird die Schaltungsanordnung von dem Wartezustand in den Aktivzustand überführt, nämlich etwa durch Betätigung der Bedieneinrichtung 8 durch eine Bedienperson, so schließt die Steuereinrichtung 7 das Relais 57. Dies erfolgt durch Anlegen einer kontinuierlichen Spannung zwischen den Anschlüssen 61, 63.

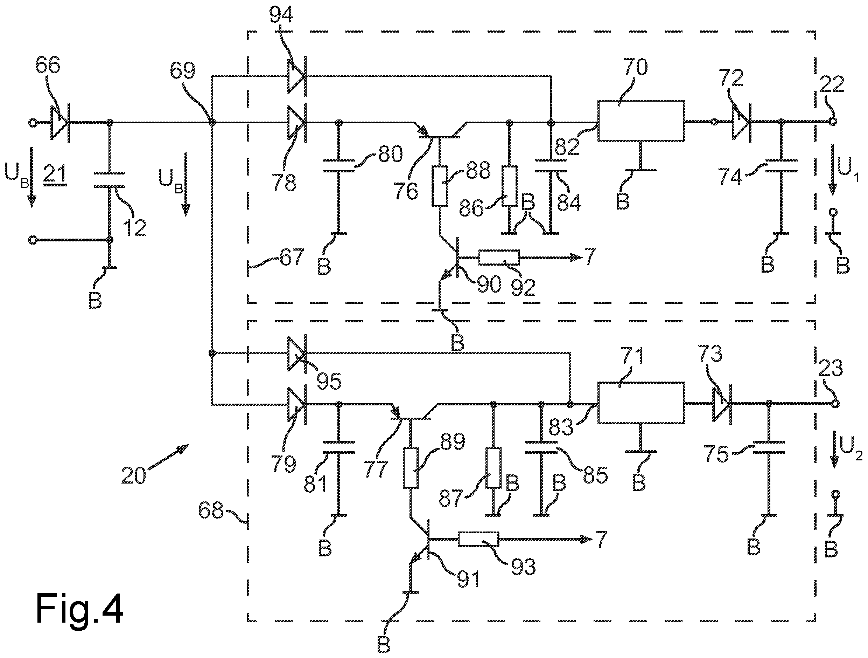

In Fig. 4 zeigt in schematischer Darstellung den Aufbau des Gleichspannungswandlers 20 der Spannungsversorgungseinheit 9. Am Eingang 21 liegt die vom Netzteil 19 bereitgestellte Betriebsgleichspannung $U_B$ von 9 V an, nämlich bezüglich des Bezugspotentials B. Mit dem Eingang 21 ist eine Diode 66 gekoppelt, parallel zum Eingang 21 ist der Energiespeicher 12 geschaltet.

An dem Energiespeicher 12 liegt also die Gleichspannung $U_B$ an. Wie bereits ausgeführt, erzeugt der Gleichspannungswandler 20 sowohl die erste als auch die zweite Gleichspannung $U_1$, $U_2$, nämlich an jeweiligen Ausgängen 22 beziehungsweise 23. Dazu umfasst der Gleichspannungswandler 20 zwei Schaltungszweige 67, 68. Beide Schaltungszweige 67, 68 sind über einen gemeinsamen Pol 69 mit dem Eingang 21 beziehungsweise mit dem Energiespeicher 12 gekoppelt. Die Schaltungszweige 67, 68 umfassen jeweils einen linearen Spannungsregler 70, 71, welcher die jeweilige Gleichspannung $U_1$ beziehungsweise $U_2$ regelt, nämlich auf 5 V beziehungsweise 3,3 V. Die linearen Spannungsregler 70, 71 sind im Ausführungsbeispiel zum extrem niedrigen Stromverbrauch ausgelegt (Low Power Voltage Regulator). Die linearen Spannungsregler 70, 71 sind jeweils über eine Diode 72, 73 mit den jeweiligen Ausgängen 22 beziehungsweise 23 gekoppelt.

Parallel zum Ausgang 22 des ersten Schaltungszweigs 67 ist ein Kondensator 74 geschaltet. Entsprechend ist ein Kondensator 75 parallel zum Ausgang 23 des zweiten Schaltungszweigs 68 geschaltet. Somit liegen die erste und die zweite Gleichspannung $U_1$, $U_2$ an dem jeweiligen Kondensator 74, 75 an.

Die Schaltungszweige 67, 68 weisen jeweils einen PNP-Bipolartransistor 76, 77 auf. Der Emitter des Bipolartransistors 76 ist über eine Diode 78 mit dem gemeinsamen Pol 69 gekoppelt. Entsprechend ist der Emitter des Bipolartransistors 77 über eine Diode 79 mit dem gemeinsamen Pol 69 gekoppelt. Die Kathoden der Dioden 78, 79 sind jeweils über einen Kondensator 80, 81 mit dem Bezugspotenzial B gekoppelt. Die Kollektoren der Bipolartransistoren 76, 77 sind jeweils mit einem Eingang 82, 83 des zugeordneten linearen Spannungsregler 70, 71 verbunden. Die Eingänge 82, 83 sind jeweils über eine Parallelschaltung aus einem Kondensator 84, 85 und einem ohmschen Widerstand 86, 87 mit dem Bezugspotenzial B gekoppelt. Die Steueranschlüsse der Bipolartransistoren 76, 77 sind jeweils über einen ohmschen Widerstand 88, 89 mit einem Kollektor eines NPN-Bipolartransistors 90, 91 gekoppelt. Die Emitter der Bipolartransistoren 90, 91 sind mit dem Bezugspotential B gekoppelt. Die Steueranschlüsse der Bipolartransistoren 90, 91 sind jeweils über einen ohmschen Widerstand 92, 93 mit der Steuereinrichtung 7 gekoppelt. Die Eingänge 82, 83 der linearen Spannungsregler 70, 71 sind darüber hinaus jeweils über eine Diode 94, 95 mit dem gemeinsamen Pol 69 gekoppelt. Die zwischen dem gemeinsamen Pol 69 und den linearen Spannungsreglern 70, 71 angeordneten Bauteile sorgen für eine noch geringere Leistungsaufnahme des Gleichspannungswandlers 20. Da die linearen Spannungsregler 70, 71 im Beispiel zum extrem geringen Stromverbrauch ausgelegt sind, kann auf diese Bauteile gegebenenfalls verzichtet werden. Werden herkömmliche lineare Spannungsregler 70, 71 eingesetzt, so können diese Bauteile eingesetzt werden, um die Leistungsaufnahme des Gleichspannungswandlers 20 zu minimieren.

Die Funktionsweise dis Gleichspannungswandlers 20 wird nachfolgend näher geschrieben. Es wird hier zwischen zwei Betriebsweisen des Gleichspannungswandlers 20 unterschieden: Gemäß der ersten Betriebsweise wird der Gleichspannungswandler 20 dann betrieben, wenn sich die Schalteinheit 10 im Koppelzustand befindet, das heißt, wenn die Versorgungswechselspannung $U_V$ am Eingang 11 der Spannungsversorgungseinheit 9 anliegt; gemäß der zweiten Betriebsweise wird der Gleichspannungswandler dann betrieben, wenn sich die Schalteinheit 10 im Entkoppelzustand befindet und lediglich die im Energiespeicher 12 enthaltene Energie für das Bereitstellen der ersten und der zweiten Gleichspannung $U_1$, $U_2$ zur Verfügung steht.

Die Betriebsweise des Gleichspannungswandlers 20 im Koppelzustand der Schalteinheit 10 ist wie folgt: Liegt die Versorgungswechselspannung $U_V$ am Eingang 11 der Spannungsversorgungseinheit 9, so stellt das Netzteil 19 die Betriebsgleichspannung $U_B$ von 9 V bereit. In diesem Fall beträgt auch die am Energiespeicher 12 anliegende Spannung $U_B$ 9 V. Die Bipolartransistoren 90, 91 werden nicht angesteuert, und die Bipolartransistoren 76, 77 verbleiben im Sperrenden Schaltzustand. Sie werden jedoch durch die jeweilige Diode 94, 95 überbrückt, so dass an den jeweiligen Eingängen 82, 83 der linearen Spannungsregler 70, 71 eine Spannung anliegt, die gleich der Betriebsgleichspannung $U_B$ ist, nämlich 9 V beträgt. Die linearen Spannungsregler 70, 71 stellen dann die erste beziehungsweise die zweite Gleichspannung $U_1$, $U_2$ bereit, nämlich aus der Betriebsgleichspannung $U_B$.

Wie bereits ausgeführt, wird die Schalteinheit 10 im Wartezustand der Schaltungsanordnung 2 nur dann in den Koppelzustand überführt, wenn die Amplitude der Betriebsgleichspannung $U_B$ den vorbestimmten Grenzwert unterschreitet. Die Schalteinheit 10 verbleibt im Koppelzustand also nur so lange, bis der Energiespeicher 12 wieder mit elektrischer Energie aufgeladen wird. Dies dauert etwa 1 s. Dann wird die Schalteinheit 10 wieder in den Entkoppelzustand überführt, nämlich durch den Mikrocontroller 24. Die Betriebsweise des Gleichspannungswandlers 20 im Entkoppelzustand der Schalteinheit 10 ist wie folgt: Im Entkoppelzustand der Schalteinheit 10 steht für die Erzeugung der ersten und der zweiten Gleichspannung $U_1$, $U_2$ lediglich die im Energiespeicher 12 enthaltene Energie zur Verfügung. Das Netzteil 19 erzeugt keine Energie. Unmittelbar nach dem Überführen der Schalteinheit 10 in den Entkoppelzustand beträgt also die Betriebsgleichspannung $U_B$ - Spannung am Energiespeicher 12 - 9 V, die Betriebsgleichspannung $U_B$ wird immer geringer werden. Unmittelbar nach dem Überführen der Schalteinheit 10 in den Entkoppelzustand sind auch die Kondensatoren 80, 81 und 84, 85 aufgeladen, die ebenfalls Energiespeicher sind. Ist der Energiespeicher 12 vollständig aufgeladen, so überbrücken die Dioden 94, 95 die jeweiligen Bipolartransistoren 76, 77, und die linearen Spannungsregler 70, 71 verbrauchen die im Energiespeicher 12 gespeicherte Energie, um die erste beziehungsweise die zweite Gleichspannung $U_1$, $U_2$ bereitzustellen. Unterschreitet die am Energiespeicher 12 anliegende Betriebsgleichspannung $U_B$ einen bestimmten Wert, so sperren die Dioden 94, 95, und die Bipolartransistoren 90, 91 werden jeweils mit einer Abfolge von Spannungsimpulsen beaufschlagt. Dann werden die Kondensatoren 80, 81 entladen, wie auch der Energiespeicher 12. Eine solche Vorgehensweise sorgt für einen energieeffizienten und verlustarmen Betrieb des Gleichspannungswandlers 20, insbesondere dann, wenn die linearen Spannungsregler 70, 71 herkömmliche Spannungsregler sind. Wie bereits ausgeführt, kann auf die zwischen dem gemeinsamen Pol 69 und dem jeweiligen linearen Spannungsregler 70, 71 angeordneten Bauteile dann verzichtet werden, wenn die linearen Spannungsregler 70, 71 Regler mit extrem geringer Leistungsaufnahme sind (Low Power Voltage Regulator).

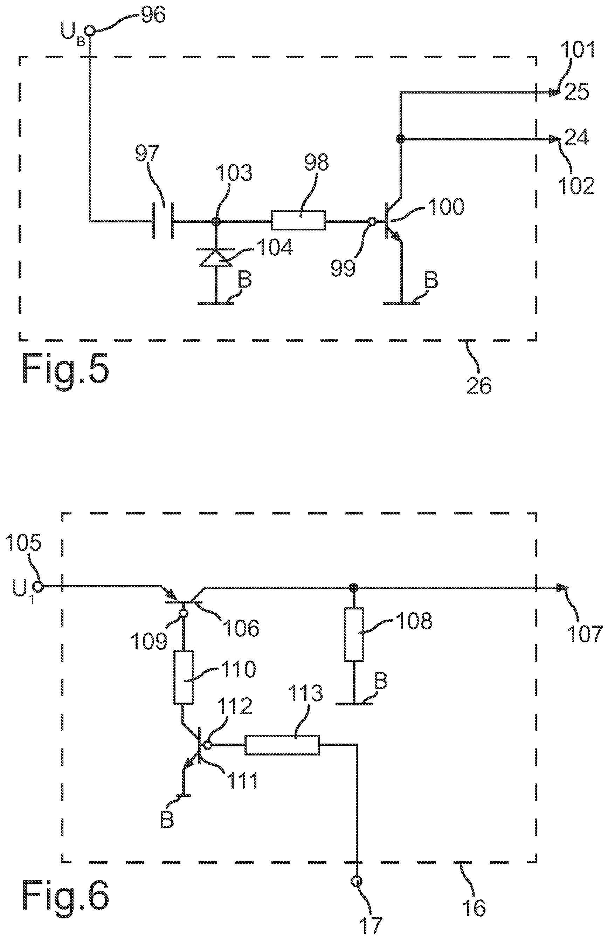

Fig. 5 zeigt in schematischer Darstellung den Aufbau der Zurücksetzungseinheit 26 gemäß Fig. 2. Die Zurücksetzungseinheit 26 weist einen Eingang 96 auf, welcher mit dem Ausgang des Netzteils 19 beziehungsweise mit dem Eingang 21 des Gleichspannungswandlers 20 gekoppelt ist. Der Eingang 96 ist über einen Kondensator 97 sowie einen ohmschen Widerstand 98 mit einem Steueranschluss 99 eines NPN-Bipolartransistors 100 gekoppelt. Der Emitter des Bipolartransistors 100 ist mit dem Bezugspotenzial B verbunden, der Kollektor des Bipolartransistors 100 ist mit einem ersten und einem zweiten Ausgang 101, 102 der Zurücksetzungseinheit 26 verbunden. Der erste Ausgang ist dann mit dem Zeitwecker 25 gekoppelt, und der zweite Ausgang 102 ist mit dem Mikrocontroller 24 gekoppelt. Ein zwischen dem Kondensator 99 und dem ohmschen Widerstand 98 angeordneter Pol 103 ist über eine Diode 104 mit dem Bezugspotenzial B gekoppelt. Dabei sind die Kathode der Diode 104 mit dem Pol 103 und die Annode mit dem Bezugspotenzial B verbunden. Die Funktionsweise der Rücksetzungseinheit 26 ist wie folgt: Die Aufgabe der Zurücksetzungseinheit 26 ist es, Spannungsimpulse auszugeben, nämlich an den Ausgängen 101, 102. Dies erfolgt jedes Mal dann, wenn die Betriebsgleichspannung $U_B$ ansteigt beziehungsweise der Energiespeicher 12 aufgeladen wird beziehungsweise die Schalteinheit 10 in den Koppelzustand überführt wird. Also werden der Zeitwecker 25 und der Mikrocontroller 24 immer dann zurückgesetzt, wenn der Energiespeicher 12 neu aufgeladen wird.

Fig. 6 zeigt in schematischer Darstellung den Aufbau der Pulserzeugungseinheit 16. Die Pulserzeugungseinheit 16 umfasst einen Eingang 105, welcher mit dem Ausgang 22 der Spannungsversorgungseinheit 9 verbunden ist. Der Eingang 105 ist mit dem Emitter eines PNP-Bipolartransistors 106 verbunden, dessen Kollektor mit einem Ausgang 107 der Pulserzeugungseinheit 16 verbunden ist. Der Kollektor des Bipolartransistors 106 ist außerdem über einen ohmschen Widerstand 108 mit dem Bezugspotenzial B gekoppelt. Ein Steueranschluss 109 des Bipolartransistors 106 ist über einen ohmschen Widerstand 110 mit dem Kollektor eines NPN-Bipolartransistors 111 gekoppelt, dessen Emitter mit dem Bezugspotenzial B verbunden ist. Ein Steueranschluss 112 des Bipolartransistors 111 ist über einen ohmschen Widerstand 113 mit dem Steueranschluss 17 der Pulserzeugungseinheit 16 gekoppelt. Dieser Steueranschluss 17 ist mit dem Mikrocontroller 24 verbunden, über den Steueranschluss 17 kann der Mikrocontroller 24 die Pulserzeugungseinheit 16 ansteuern beziehungsweise Spannungsimpulse am Ausgang 107 bereitstellen. Die Funktionsweise der Pulserzeugungseinheit 16 ist wie folgt: Um Spannungsimpulse am Ausgang 107 aus der ersten Gleichspannung $U_1$ zu erzeugen, wird der Steueranschluss 112 des Bipolartransistors 111 mit einer Abfolge von Spannungsimpulsen beaufschlagt, dann wird der Steueranschluss 109 des Bipolartransistors 106 gegen das Bezugspotenzial B gezogen, und der Bipolartransistor 106 wird leitend. Auf diesem Wege werden am Ausgang 107 Spannungsimpulse bereitgestellt, deren Amplitude gleich der Amplitude der ersten Gleichspannung $U_1$ ist.

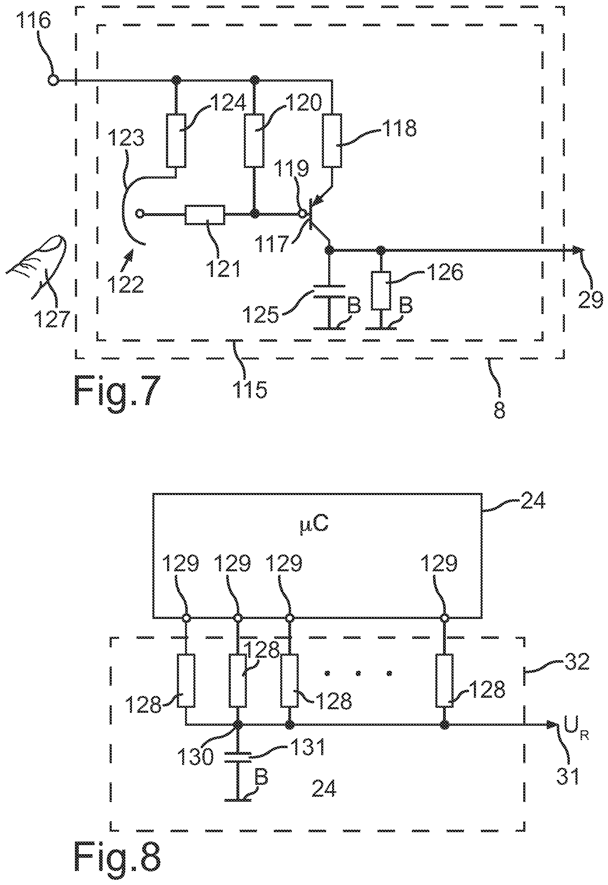

Fig. 7 zeigt in schematischer Darstellung den Aufbau der Bedieneinrichtung 8. Die Bedieneinrichtung 8 umfasst einen kapazitiven Annäherungssensor 115, welcher einen Eingang 116 sowie den Ausgang 29 aufweist. Der Eingang 116 ist mit dem Ausgang 107 der Pulserzeugungseinheit 16 verbunden, der Ausgang 29 ist mit dem positiven Eingang 28 des Komparators 27 verbunden. Der kapazitive Annäherungssensor 115 umfasst außerdem einen PNP-Bipolartransistor 117, dessen Emitter über einen ohmschen Widerstand 118 mit dem Eingang 116 gekoppelt ist. Ein Steueranschluss 119 des Bipolartransistors 117 ist über einen ohmschen Widerstand 120 mit dem Eingang 116 sowie über einen ohmschen Widerstand 121 mit einem Kondensator 122 gekoppelt. Eine Sensorelektrode 123 des Kondensators 122 ist über einen ohmschen Widerstand 124 mit dem Eingang 116 gekoppelt. Der Kollektor des Bipolartransistors 117 ist mit dem Ausgang 29 verbunden, wie auch über eine Parallelschaltung aus einem Kondensator 125 und einem ohmschen Widerstand 126 mit dem Bezugspotenzial B gekoppelt. Der Kapazitätswert des Kondensators 125 beträgt im Ausführungsbeispiel 1 nF, dieser Kapazitätswert kann jedoch in einem Wertebereich von 500 pF bis 50 nF, noch bevorzugter in einem Wertebereich von 800 pF bis 10 nF liegen. Also ist der Kapazitätswert des Kondensators 125 relativ gering.

Die Funktionsweise des kapazitiven Annäherungssensors 115 wird nachfolgend näher erläutert. Wird der kapazitive Annäherungssensor 115 - über den Eingang 116 - mit einer Abfolge von Spannungsimpulsen beaufschlagt, so erzeugt der Annäherungssensor 115 am Ausgang 29 ebenfalls Spannungsimpulse. Die Amplitude dieser Spannungsimpulse ist dann abhängig von der Kapazität des Kondensators 122. Dabei stellt die Sensorelektrode 123 ein Bedienelement dar: Durch Annäherung eines Gegenstands, der ein von dem Bezugspotential B unterschiedliches Potential, insbesondere das Potential der Erde führt, wird die Kapazität des Kondensators 122 verändert. Also kann eine Bedienperson einen Finger 127 an die Sensorelektrode 123 annähern, um die Kapazität des Kondensators 122 zu verändern und somit die Amplitude der vom Annäherungssensor 115 ausgegebenen Spannungsimpulse zu verändern. Es gilt dabei die Beziehung, dass die Amplitude der am Ausgang 29 ausgegebenen Spannungsimpulse höher ist, wenn eine Bedienperson den Annäherungssensor 115 betätigt beziehungsweise wenn sich der Finger 127 in der Umgebung der Sensorelektrode 123 befindet.

Fig. 8 zeigt in schematischer Darstellung den Aufbau des Digital-Analog-Wandlers 32, welcher mit dem Mikrocontroller 24 gekoppelt ist. Der Digital-Analog-Wandler 32 umfasst eine Vielzahl von ohmschen Widerständen 128, die einerseits mit jeweils einem Ausgang 129 des Mikrocontrollers 24 gekoppelt sind und andererseits an einem gemeinsamen Pol 130 zusammen geführt sind. Der gemeinsame Pol 130 ist über einen Kondensator 131 mit dem Bezugspotential B gekoppelt, wie auch mit dem Ausgang 31 des Digital-Analog-Wandlers 32 verbunden. Am Ausgang 31 stellt der Digital-Analog-Wandler 32 ein Referenzsignal $U_R$ bereit, welches eine elektrische Spannung ist. Die Amplitude des Referenzsignals $U_R$ kann der Mikrocontroller 24 stufenweise verändern, nämlich durch Bestromen unterschiedlicher Anzahl von ohmschen Widerständen 128. Das Referenzsignal $U_R$ liegt dann am negativen Eingang 30 des Komparators 27 an.

Bezugnehmend im Allgemeinen auf Fig. 2 wird nun die Funktionsweise der Schaltungsanordnung 2 im Ganzen näher beschrieben. Zunächst wird der Schaltungseingang 3 mit dem Versorgungsnetz 6 gekoppelt, und es liegt die Versorgungsspannung $U_V$ an dem Schaltungseingang 3 an. Die Schalteinheit 10 überführt sich selbst - wie oben ausgeführt - in den Koppelzustand, in welchem die Spannungsversorgungseinrichtung 9 mit dem Schaltungseingang 3 gekoppelt ist. Der Energiespeicher 12 wird aufgeladen. Der Mikrocontroller 24 wird in Betrieb genommen, und er überführt die Schalteinheit 10 in den Entkoppelzustand, nämlich durch Beaufschlagen des Optokopplers 58 (Fig. 3) mit einem Spannungsimpuls und somit durch Entladen der Speichereinheit 50 (Fig. 3). Nun ist die Schaltungsanordnung 2 von dem elektrischen Versorgungsnetz 6 entkoppelt, und es wird keine Energie aus dem Versorgungsnetz 6 aufgenommen. Die im Energiespeicher 12 enthaltene elektrische Energie reicht dann für einige hundert Sekunden aus, nämlich etwa für 1000 s. Der Optokoppler 58 wird durch den Mikrocontroller 24 periodisch mit Spannungsimpulsen beaufschlagt. Somit wird auch die Speichereinheit 50 periodisch entladen, und die Schalteinheit wird in dem Entkoppelzustand gehalten. Der Optokoppler 58 kann zum Beispiel in Zeitabständen von etwa 1 s mit jeweils mit einem Spannungsimpuls beaufschlagt werden.

Der Zeitwecker 25 weckt den Mikrocontroller 24 in vorbestimmten Zeitabständen, nämlich im Ausführungsbeispiel alle 100 ms, und überführt den Mikrocontroller 24 so in den Wachzustand. Diese Zeitabstände können in einem Wertebereich von 40 ms bis 100 ms liegen. Also wird der Mikrocontroller 24 im Beispiel alle 100 ms aus dem Schlafzustand in den Wachzustand überführt. Wird der Mikrocontroller 24 in den Wachzustand geschaltet, so überprüft er, ob eine Bedienperson den Annäherungssensor 115 betätigt oder nicht. Wird dies bestätigt, so überführt der Mikrocontroller 24 die Schaltungsanordnung 2 von dem Wartezustand in den Aktivzustand, in dem der Mikrocontroller 24 das Relais 57 (Fig. 3) schließt. Im Aktivzustand werden dann die elektrischen Verbraucher 13 des Haushaltsgeräts 1 in Betrieb genommen.

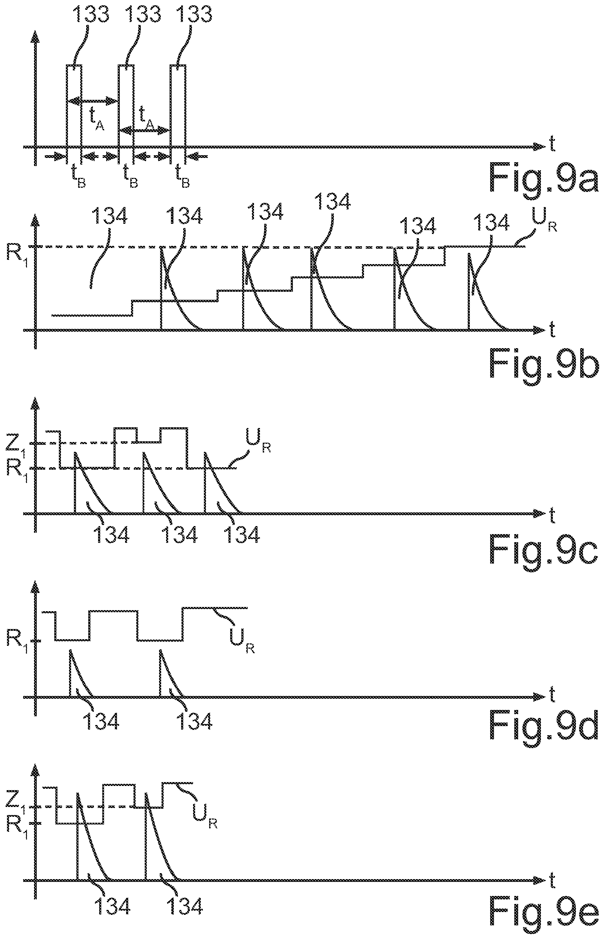

Um zu überprüfen, ob eine Bedienperson den Annäherungssensor 115 betätigt oder nicht, beaufschlagt der Mikrocontroller 24 - nach jedem Übergang in den Wachzustand - den Annäherungssensor 115 mit einer vorbestimmten Anzahl von Spannungsimpulsen, z. B. mit zwei, drei oder vier Spannungsimpulsen. Mit dieser vorbestimmten Anzahl von Spannungsimpulsen wird der Annäherungssensor 115 also immer dann beaufschlagt, wenn der Mikrocontroller 24 in den Wachzustand überführt wird, also alle 100 ms. Eine solche Abfolge von an den Annäherungssensor 115 abgegebenen Spannungsimpulsen 133 ist in Fig. 9a dargestellt. Auf der x-Achse ist die Zeit t aufgetragen. Die Amplitude der Spannungsimpulse 133 ist gleich der Amplitude der ersten Gleichspannung $U_1$. Zum Beispiel werden hier drei Spannungsimpulse 133 an den Annäherungssensor 115 abgegeben. Die Pulsbreite $t_B$ beträgt im Ausführungsbeispiel z. B. 20 µs. Die Pulsbreite $t_B$ kann in einem Wertebereich von 10 µs bis 50 µs liegen. Der zeitliche Abstand $t_A$ zwischen zwei nacheinander folgenden Spannungsimpulsen 133 beträgt im Ausführungsbeispiel 60 µs. Der zeitliche Abstand $t_A$ kann in einem Wertebereich von 60 µs bis 100 µs liegen. Solche Abfolge von drei Spannungsimpulsen 133 wird an den Annäherungssensor 115 abgegeben. Entsprechend gibt der Annäherungssensor 115 Spannungsimpulse aus, die durch die Steuereinrichtung 7 ausgewertet werden.

Die vom Annäherungssensor 115 ausgegebenen Spannungsimpulse werden an den positiven Eingang 28 des Komparators 27 geführt. An dem negativen Eingang 30 liegt das Referenzsignal $U_R$. Ist die Amplitude der vom Annäherungssensor 115 ausgegebenen Spannungsimpulse größer als die Amplitude des Referenzsignals $U_R$, so gibt der Komparator 27 eine logische "Eins" aus. Ist die Amplitude des Spannungsimpulses kleiner als die Amplitude des Referenzsignals $U_R$, so gibt der Komparator 27 eine logische "Null" aus.

Die Auswertung der vom Annäherungssensor 115 ausgegebenen Spannungsimpulse wird nachfolgend näher beschrieben. Zuerst - d.h. unmittelbar nach dem Koppeln des Schaltungseingangs 3 mit dem elektrischen Versorgungsnetz 6 beziehungsweise unmittelbar nach einem ersten Aufladen des Energiespeichers 12 - erfolgt eine Kalibrierung des Referenzsignals $U_R$. Der Ablauf dieser Kalibrierung ist in Fig. 9b gezeigt. Der Mikrocontroller 24 beaufschlagt den Annäherungssensor 115 mit einer Abfolge von Spannungsimpulsen. Der Annäherungssensor 115 gibt entsprechend eine Abfolge von Spannungsimpulsen 134 gemäß Fig. 9b aus. Der Mikrocontroller 24 erhöht stufenweise die Amplitude des Referenzsignals $U_R$, bis diese Amplitude die Amplitude der Spannungsimpulse 134 überschreitet. Nach Abschluss der Kalibrierung legt der Mikrocontroller 24 einen ersten Referenzwert $R_1$ des Referenzsignals $U_R$ fest. Dieser erste Referenzwert $R_1$ wird zu Beginn des Betriebs der Schaltungsanordnung 2 als Referenz für die Spannungsimpulse 134 verwendet. Und zwar wird abhängig von dem ersten Referenzwert $R_1$ ein Wertebereich bestimmt, dessen unterer Grenzwert gleich dem ersten Referenzwert $R_1$ ist. Der obere Grenzwert kann bezüglich des unteren Grenzwerts vordefiniert werden. Also wird zu Beginn des Betriebes der Schaltungsanordnung 2 ein Wertebereich von $R_1$ bis $Z_1$ bestimmt.

Wie bereits ausgeführt, überprüft der Mikrocontroller 24 alle 100 ms, ob eine Bedienperson den Annäherungssensor 115 betätigt oder nicht. Alle 100 ms beaufschlagt der Mirkocontroller 24 den Annäherungssensor 115 mit zum Beispiel drei Spannungsimpulsen 133. Der Mikrocontroller 24 überprüft dann, ob die Amplitude der vom Annäherungssensor 115 ausgegebenen Spannungsimpulse 134 innerhalb des bestimmten Wertebereichs von $R_1$ bis $Z_1$ liegt. Wird dies bestätigt, so wird die Schaltungsanordnung 2 in den Aktivzustand überführt.

Ein Beispiel für eine korrekte Betätigung ist in Fig. 9c dargestellt. Der Mikrocontroller 24 verändert die Amplitude des Referenzsignals $U_R$, nämlich zwischen dem unteren Grenzwert $R_1$ und dem oberen Grenzwert $Z_1$ des Wertebereichs. Aus Fig. 9c geht hervor, dass die Amplitude der Spannungsimpulse 134 innerhalb des Wertebereichs von $R_1$ bis $Z_1$ liegt. Der Mikrocontroller 24 erkennt also, dass eine Bedienperson den Annäherungssensor 115 betätigt, um die Schaltungsanordnung 2 in den Aktivzustand zu schalten.

In Fig. 9d ist der Fall gezeigt, in welchem keine Betätigung des Annäherungssensors 115 vorliegt. Die Amplitude der Spannungsimpulse 134 ist nämlich geringer als der untere Grenzwert $R_1$ des Wertebereichs.

Ein Beispiel für eine nicht-korrekte Betätigung des Annäherungssensors 115 ist in Fig. 9e abgebildet. Wie aus Fig. 9e hervorgeht, liegt die Amplitude der Spannungsimpulse 134 oberhalb des oberen Grenzwerts $Z_1$ des Wertebereichs. Der Mikrocontroller 24 erkennt also, dass eine nicht-korrekte Betätigung des Annäherungssensors 115 vorliegt, und die Schaltungsanordnung 2 wird nicht in den Aktivzustand überführt.

Die Amplitude der vom Annäherungssensor 115 ausgegebenen Spannungsimpulse 134 hängt jedoch nicht nur von der Kapazität des Kondensators 122 (Fig. 7) ab, sondern auch von Umgebungsbedingungen, wie Temperatur und dergleichen, sowie von der Amplitude der ersten Gleichspannung $U_1$. Um die Veränderung der Amplitude der Spannungsimpulse 134 durch etwaige Störgrößen zu berücksichtigen, wird der Wertebereich $R_1$ bis $Z_1$ mit der Zeit angepasst; der Wertebereich wird also stets verändert - somit werden die Grenzwerte nachfolgend allgemein als $R_x$ und $Z_x$ bezeichnet. Und zwar wird der untere Grenzwert $R_x$ abhängig von der Amplitude der empfangenen Spannungsimpulse 134 erneut bestimmt. Der obere Grenzwert $Z_x$ wird dann entsprechend angepasst.

Die Bestimmung des unteren Grenzwerts $R_x$ ergibt sich nach der Formel:

$$R_n = R_{n-1} + K^*(R_{n-1} - A_n),$$

wobei $R_n$ den aktuellen unteren Grenzwert des Wertebereichs, $R_{n-1}$ den vorangegangenen unteren Grenzwert des Wertebereichs, K einen Faktor kleiner eins und $A_n$ die aktuelle Amplitude des empfangenen Spannungsimpulses 134 bezeichnen.

Es wird also eine Art gleitendes Mittel für den unteren Grenzwert $R_x$ berechnet, so dass etwaige Störgrößen bei der Auswertung der Spannungsimpulse 134 mitberücksichtigt werden, wie insbesondere die Temperatur sowie die aktuelle Amplitude der ersten Gleichspannung $U_1$. Es kann auch vorgesehen sein, dass die Amplitude der ersten Gleichspannung $U_1$ durch den Mikrocontroller 24 gemessen wird und der untere Grenzwert $R_x$ abhängig von der aktuellen Amplitude der ersten Gleichspannung $U_1$ angepasst wird. Es kann auch vorgesehen sein, dass der Mikrocontroller 24 auf die Amplitude der ersten Gleichspannung $U_1$ abhängig von der Auswertung der Amplitude der zweiten Gleichspannung $U_2$ zurückschließt.

Die Leistungsaufnahme einzelner Komponenten der Schaltungsanordnung 2 ist wie folgt:

- die Leistungsaufnahme der Spannungsversorgungseinheit 9 beträgt etwa 20 bis 30 $\mu$W,
- die Leistungsaufnahme der Zurücksetzungseinheit beträgt etwa 9 $\mu$W,
- die Leistungsaufnahme des Mikrocontrollers 24 einschließlich des Zeitweckers 25 und des Komparators 27 beträgt etwa 90 $\mu$W,
- die Leistungsaufnahme der Schalteinheit 10 beträgt etwa 1,4 mW,
- die Leistungsaufnahme des Netzfilters 15 beträgt etwa 340 $\mu$W,
- die Leistungsaufnahme des Digital-Analog-Wandlers 32 beträgt etwa 110 $\mu$W,
- die Leistungsaufnahme der Bedieneinrichtung 8 beträgt etwa 23 $\mu$W,
- die Leistungsaufnahme des Optokopplers 58 beträgt etwa 30 $\mu$W und
- die Leistungsaufnahme des Netzteils 14 beträgt etwa 2,5 mW.

27 EP 2 315 338 B1 28

Insgesamt hat sich herausgestellt, dass die Schaltungsanordnung 2 eine Leistungsaufnahme von etwa 5 mW aufweist. Dabei verbraucht die Schaltungsanordnung 2 fast gesamte Leistung während der Zeit, in welcher der Energiespeicher 12 aufgeladen wird. Dies dauert jedoch ganz kurz, nämlich 1 s. Dann verbleibt die Schaltungsanordnung 2 für etwa 1000 s von dem Versorgungsnetz 6 entkoppelt. Auf diese Art und Weise wird insgesamt eine Schaltungsanordnung 2 bereitgestellt, die sich durch eine extrem geringe Leistungsaufnahme im Wartezustand (Stand-by-Zustand) auszeichnet.

**Bezugszeichenliste**

| | |
|---|---|
| 1 | Haushaltsgerät |
| 2 | Schaltungsanordnung |
| 3 | Schaltungseingang |
| 4, 5 | Eingangsanschlüsse |
| 6 | Versorgungsnetz |
| 7 | Steuereinrichtung |
| 8 | Bedieneinrichtung |
| 9 | Spannungsversorgungseinheit |
| 10 | Schalteinheit |
| 11 | Eingang der Spannungsversorgungseinheit 9 |
| 12 | Energiespeicher |
| 13 | elektrische Verbraucher |
| 14 | Netzteil |
| 15 | Netzfilter |
| 16 | Pulserzeugungseinheit |
| 17 | Steueranschluss |
| 18 | Treiber |
| 19 | Netzteil |
| 20 | Gleichspannungswandler |
| 21 | Eingang des Gleichspannungswandlers 20 |
| 22 | erster Ausgang |
| 23 | zweiter Ausgang |
| 24 | Mikrocontroller |
| 25 | Zeitwecker |
| 26 | Zurücksetzungseinheit |
| 27 | Komparator |
| 28 | positiver Eingang des Komparators 27 |
| 29 | Ausgang der Bedieneinrichtung 8 |
| 30 | negativer Eingang des Komparators 27 |
| 31 | Ausgang des Digital-Analog-Wandlers 32 |
| 32 | Digital-Analog-Wandler |
| 33 | Versorgungsanschluss des Komparators 27 |
| 34 | Ausgang des Komparators 27 |
| 35 | Eingang des Mikrocontrollers 24 |
| 36 | Speicher |
| 37 | Phasenleiter |
| 38 | Neutralleiter |
| 39 | Abgriffeinheit |
| 40 | Diode |
| 41 | ohmsche Widerstände |
| 42 | Spannungsteilerpol |
| 43 | Zenerdiode |
| 44 | ohmscher Widerstand |
| 45 | Kondensator |
| 46 | Zenerdiode |
| 47 | Steueranschluss des Halbleiterschalters 48 |
| 48 | Halbleiterschalter |
| 49 | ohmscher Widerstand |
| 50 | Speichereinheit |
| 51 | Emitter des Halbleiterschalters 48 |
| 52 | erster Pol |
| 53 | Kollektor des Halbleiterschalters 48 |
| 54 | Diode |
| 55 | ohmscher Widerstand |
| 56 | zweiter Pol |
| 57 | Relais |
| 58 | Optokoppler |
| 59 | Leuchtdiode |
| 60 | Fototransistor |
| 61 | Anschluss |
| 62 | Kondensator |
| 63 | Anschluss |
| 64 | Diode |
| 65 | Steuerelement |
| 66 | Diode |
| 67, 68 | Schaltungszweige |
| 69 | gemeinsamer Pol |
| 70, 71 | lineare Spannungsregler |
| 72, 73 | Dioden |
| 74, 75 | Kondensatoren |
| 76, 77 | PNP-Bipolartransistoren |
| 78, 79 | Dioden |
| 80, 81 | Kondensatoren |
| 82, 83 | Eingänge |
| 84, 85 | Kondensatoren |
| 86, 87 | ohmsche Widerstände |
| 88, 89 | ohmsche Widerstände |
| 90, 91 | NPN-Bipolartransistoren |
| 92, 93 | ohmsche Widerstände |
| 94, 95 | Dioden |
| 96 | Eingang der Zurücksetzungseinheit 26 |
| 97 | Kondensator |
| 98 | ohmscher Widerstand |
| 99 | Steueranschluss des Bipolartransistors 100 |
| 100 | N PN-Bipolartransistor |
| 101, 102 | Ausgänge der Zurücksetzungseinheit 26 |
| 103 | Pol |
| 104 | Diode |
| 105 | Eingang der Pulserzeugungseinheit 16 |

15

| | |
|---|---|
| 106 | PNP-Bipolartransistor |
| 107 | Ausgang der Pulserzeugungseinheit 16 |
| 108 | ohmscher Widerstand |
| 109 | Steueranschluss des Bipolartransistors 106 |
| 110 | ohmscher Widerstand |
| 111 | NPN-Bipolartransistor |
| 112 | Steueranschluss des Bipolartransistors 111 |
| 113 | ohmscher Widerstand |
| 115 | Annäherungssensor |
| 116 | Eingang des Annäherungssensors 115 |
| 117 | PNP-Bipolartransistor |
| 118 | ohmscher Widerstand |
| 119 | Steueranschluss des Bipolartransistors 117 |
| 120, 121 | ohmsche Widerstände |
| 122 | Kondensator |
| 123 | Sensorelektrode |
| 124 | ohmscher Widerstand |
| 125 | Kondensator |
| 126 | ohmscher Widerstand |
| 127 | Finger |
| 128 | Vielzahl von ohmschen Widerständen |
| 129 | Ausgänge des Mikrocontrollers 24 |
| 130 | Pol |
| 131 | Kondensator |
| 133, 134 | Spannungsimpulse |
| $A_n$ | Amplitude |
| B | Bezugspotential der Steuereinrichtung 7 |
| K | Faktor kleiner eins |
| $U_1$ | erste Gleichspannung |
| $U_2$ | zweite Gleichspannung |
| $U_B$ | Betriebsgleichspannung |
| $U_{V'}$ | Versorgungswechselspannung |
| $U_x$ | elektrische Spannung |
| $U_R$ | Referenzsignal |
| $R_x, R_1, R_n, R_{n-1}$ | untere Grenzwerte |
| $Z_x, Z_1$ | obere Grenzwerte |
| $t_A$ | zeitlicher Abstand |
| $t_B$ | Pulsbreite |

**Patentansprüche**

1. Schaltungsanordnung (2) zum Betreiben eines Haushaltsgeräts (1), mit

- einem Schaltungseingang (3) mit einem ersten und einem zweiten Eingangsanschluss (4, 5) zum Koppeln der Schaltungsanordnung (2) mit einem elektrischen Versorgungsnetz (6), wobei an den Schaltungseingang (3) eine Versorgungswechselspannung ($U_V$) des Versorgungsnetzes (6) anlegbar ist,
- einer Spannungsversorgungseinheit (9), die zum Bereitstellen einer Betriebsgleichspannung ($U_B$) aus der Versorgungswechselspannung ($U_V$) ausgebildet ist und einen Energiespeicher (12) aufweist, an welchem die Betriebsgleichspannung ($U_B$) anliegt,
- einer zwischen dem Schaltungseingang (3) und der Spannungsversorgungseinheit (9) gekoppelten Schalteinheit (10), die zwischen einem Koppelzustand, in welchem die Spannungsversorgungseinheit (9) mit dem Schaltungseingang (3) elektrisch gekoppelt ist, und einem Entkoppelzustand, in welchem die Spannungsversorgungseinheit (9) von dem Schaltungseingang (3) entkoppelt ist, schaltbar ist,
- einer Steuereinrichtung (7) zum Ansteuern der Schalteinheit (10), wobei die Steuereinrichtung (7) mit elektrischer Energie aus dem Energiespeicher (12) versorgbar ist, und
- einer mit der Steuereinrichtung (7) gekoppelten Bedieneinrichtung (8), die mit elektrischer Energie aus dem Energiespeicher (12) versorgbar ist und mittels welcher die Schaltungsanordnung (2) zwischen einem Wartezustand und einem Aktivzustand überführbar ist,

wobei die Steuereinrichtung (7) dazu ausgelegt ist, nach Aufladen des Energiespeichers (12) in dem Wartezustand der Schaltungsanordnung (2) die Schalteinheit (10) in den Entkoppelzustand zu überführen,

**dadurch gekennzeichnet, dass** die Schalteinheit (10) umfasst:

- einen Halbleiterschalter (48), über welchen die Spannungsversorgungseinheit (9) mit dem Schaltungseingang (3) koppelbar ist, wobei parallel zum Halbleiterschalter (48) ein gekoppelter elektrischen Schalter (57) vorgesehen ist, und wobei die Steuereinrichtung (7) dazu ausgelegt ist, beim Überführen der Schaltungsanordnung (2) von dem Wartezustand in den Aktivzustand den elektrischen Schalter (57) in seinen elektrisch leitenden Schaltzustand zu schalten,
- eine Speichereinheit (50), über welche ein Steueranschluss (47) des Halbleiterschalters (48) mit dem zweiten Eingangsanschluss (5) des Schaltungseingangs (3) gekoppelt ist, wobei durch Aufladen der Speichereinheit (50) mit elektrischer Energie der Halbleiterschalter (48) in seinen elektrisch leitenden Schaltzustand überführbar ist, ohne dass die Steuereinrichtung (7) notwendigerweise Steuersignale an die Schalteinheit (10) ausgibt, wobei die Speichereinheit (50) zwischen dem Steueranschluss (47) und dem zweiten Einganganschluss (5, 38), sowie einem Spannungsteilerpol (42) an den Steueranschluss angekoppelt ist und

- eine mit dem Steueranschluss (47) des Halbleiterschalters (48) gekoppelte Abgriffeinheit (39), die zum Abgreifen der Versorgungswechselspannung ($U_V$) an dem Schaltungseingang (3) und zum Bereitstellen einer davon abgeleiteten elektrischen Spannung ($U_x$) an der Speichereinheit (50) ausgebildet ist, wobei die Abgriffeinheit (39) einen zwischen Spannungsteilerpol (42) und Schaltungseingang (3) gekoppelten gleichrichtenden zwischen Spannungsteiler, der aus einer Diode (40) und zwei Widerständen (41, 44) gebildet ist, umfasst.

2. Schaltungsanordnung (2) nach Anspruch 1, **dadurch gekennzeichnet, dass** die Steuereinrichtung (7) dazu ausgelegt ist, die Schalteinheit (10) in dem Entkoppelzustand durch Entladen der Speichereinheit (50), insbesondere durch periodisches Entladen der Speichereinheit (50), zu halten.

3. Schaltungsanordnung (2) nach einem der vorhergehenden Ansprüche, **dadurch gekennzeichnet, dass** die Steuereinrichtung (7) dazu ausgelegt ist, die Schalteinheit (10) in den Koppelzustand durch Aussetzen der Entladung der Speichereinheit (50) zu schalten.

4. Schaltungsanordnung (2) nach einem der vorhergehenden Ansprüche, **dadurch gekennzeichnet, dass** die Steuereinrichtung (7) dazu ausgelegt ist, in dem Wartezustand der Schaltungsanordnung (2) die Schalteinheit (10) solange in dem Entkoppelzustand zu halten, bis die Amplitude der Betriebsgleichspannung ($U_B$) einen vorbestimmten Grenzwert unterschreitet.

5. Schaltungsanordnung (2) nach einem der vorhergehenden Ansprüche, **dadurch gekennzeichnet, dass** die Steuereinrichtung (7) dazu ausgelegt ist, die Amplitude der Betriebsgleichspannung ($U_B$) zu erfassen und in dem Wartezustand der Schaltungsanordnung (2) die Schalteinheit (10) dann von dem Entkoppelzustand in den Koppelzustand zu schalten, wenn die Betriebsgleichspannung ($U_B$) einen vorbestimmten Grenzwert unterschreitet.

6. Schaltungsanordnung (2) nach einem der vorhergehenden Ansprüche, **dadurch gekennzeichnet, dass** die Bedieneinrichtung (8) einen Annäherungssensor (115), insbesondere einen kapazitiven Annäherungssensor (115), umfasst, dessen Eingang (116) mit der Spannungsversorgungseinheit (9) und dessen Ausgang (29) mit der Steuereinrichtung (7) gekoppelt ist, und die Steuereinrichtung (7) dazu ausgelegt ist, ein Ausgangssignal (134) des Annäherungssensors (115) auszuwerten und abhängig vom Ergebnis dieser Auswertung eine Betätigung des Annäherungssensors (115) durch eine Bedienperson zu erkennen.

7. Schaltungsanordnung (2) nach Anspruch 6, **dadurch gekennzeichnet, dass** der Annäherungssensor (115) umfasst:

   - einen Transistor (117), dessen Kollektor mit dem Ausgang (29) des Annäherungssensors (115) gekoppelt ist, und
   - einen Kondensator (122), dessen Kapazitätswert durch Annäherung veränderbar ist und der mit einem Steueranschluss (119) des Transistors (117) gekoppelt ist,

   wobei der Steueranschluss (119) und der Emitter des Transistors (117) mit dem Eingang (116) des Annäherungssensors (115) gekoppelt sind.

8. Schaltungsanordnung (2) nach Anspruch 6 oder 7, **dadurch gekennzeichnet, dass** die Steuereinrichtung (7) dazu ausgelegt ist, in vorbestimmten Zeitabständen jeweils ein Beaufschlagen des Annäherungssensors (115) mit einer vorbestimmten Anzahl von Spannungsimpulsen (133) aus dem Energiespeicher (12) zu veranlassen, um anhand des Ausgangssignals (134) des Annäherungssensors (115) zu erkennen, ob eine Bedienperson den Annäherungssensor (115) betätigt, wobei bevorzugt die Zeitdauer ($t_B$) eines einzelnen Spannungsimpulses (133) in einem Wertebereich von 10 $\mu$s bis 50 $\mu$s liegt und/oder der zeitliche Abstand ($t_A$) zwischen zwei nacheinander folgenden Spannungsimpulsen (133) in einem Wertebereich von 60 $\mu$s bis 100 $\mu$s liegt.

9. Schaltungsanordnung (2) nach einem der Ansprüche 6 bis 8, **dadurch gekennzeichnet, dass** die Steuereinrichtung (7) dazu ausgebildet ist, das Ausgangssignal (134) des Annäherungssensors (115) mit einem Referenzsignal ($U_R$) zu vergleichen und abhängig von dem Vergleich zu erkennen, ob eine Bedienperson den Annäherungssensor (115) betätigt, wobei bevorzugt die Steuereinrichtung (7) dazu ausgelegt ist, durch Veränderung der Amplitude des Referenzsignals ($U_R$) die absolute Amplitude des Ausgangssignals (134) des Annäherungssensors (115) zu ermitteln.

10. Schaltungsanordnung (2) nach einem der Ansprüche 6 bis 9, **dadurch gekennzeichnet, dass** die Steuereinrichtung (7) dazu ausgelegt, eine Betätigung des Annäherungssensors (115) durch eine Bedienperson dann zu bestätigen, wenn die Amplitude eines Spannungsimpulses (134) des Ausgangssignals des Annäherungssensors (115) innerhalb eines bestimmten Wertebereichs ($R_x$ bis $Z_x$) liegt.

**11.** Schaltungsanordnung (2) nach Anspruch 10, **dadurch gekennzeichnet, dass** die Steuereinrichtung (7) dazu ausgelegt ist, nach Empfangen eines Spannungsimpulses (134) des Ausgangssignals des Annäherungssensors (115) den Wertebereich ($R_x$ bis $Z_x$) für die Auswertung nachfolgender Spannungsimpulse (134) abhängig von der Amplitude des empfangenen Spannungsimpulses (134) erneut zu bestimmen.

**12.** Haushaltsgerät (1) mit einer Schaltungsanordnung (2) nach einem der vorhergehenden Ansprüche.

**13.** Verfahren zum Betreiben einer Schaltungsanordnung (2) in einem Haushaltsgerät (1), die zwischen einem Wartezustand und einem Aktivzustand überführbar ist, mit den Schritten:

- Anlegen einer Versorgungswechselspannung ($U_V$) an einen Schaltungseingang (3) der Schaltungsanordnung (2),
- Schalten einer Schalteinheit (10) von einem Entkoppelzustand, in welchem eine Spannungsversorgungseinheit (9) von dem Schaltungseingang (3) entkoppelt ist, in einen Koppelzustand, in welchem die Spannungsversorgungseinheit (9) mit dem Schaltungseingang (3) elektrisch gekoppelt ist,
- Bereitstellen einer Betriebsgleichspannung ($U_B$) aus der Versorgungswechselspannung ($U_V$) durch die Spannungsversorgungseinheit (9) und Aufladen eines Energiespeichers (12) mit elektrischer Energie, wobei an dem Energiespeicher (12) die Betriebsgleichspannung ($U_B$) anliegt,
- Überführen der Schalteinheit (10) in den Entkoppelzustand nach dem Aufladen des Energiespeichers (12),

**gekennzeichnet durch** die weiteren Schritte:

- Abgreifen der Versorgungswechselspannung ($U_V$) an dem Schaltungseingang (3) durch eine mit dem Steueranschluss (47) des Halbleiterschalters (48) gekoppelte, einen zwischen Spannungsteilerpol (42) und Schaltungseingang (3) gekoppelten gleichrichtenden Spannungsteiler, der aus einer Diode (40) und zwei Widerständen (41, 44) gebildet ist, umfassende Abgriffeinheit (39),
- Bereitstellen einer von der Versorgungswechselspannung ($U_V$) abgeleiteten elektrischen Spannung ($U_X$) an einer Speichereinheit (50), über welche ein Steueranschluss (47) eines Halbleiterschalters (48) mit einem zweiten Eingangsanschluss (5) des Schaltungseingangs (3) gekoppelt ist,
- Überführen des Halbleiterschalters (48) in seinen elektrisch leitenden Schaltzustand durch Aufladen der Speichereinheit (50) mit elektrischer Energie, und hierdurch
- Koppeln der Spannungsversorgungseinheit (9) mit dem Schaltungseingang (3) über den Halbleiterschalter (48).

## Claims

**1.** Switching assembly (2) for operating a household device (1), having

- a switching input (3) with a first and a second input terminal (4, 5) for coupling the switching assembly (2) to an electric power supply network (6), wherein an alternating supply voltage ($U_V$) of the power supply network (6) can be applied to the switching input (3),
- a voltage supply unit (9) which is embodied to provide a direct operating voltage ($U_B$) from the alternating supply voltage ($U_V$) and has an energy storage device (12) to which the direct operating voltage ($U_B$) is applied,
- a switching unit (10) coupled between the switching input (3) and the voltage supply unit (9), which can be switched between a coupled state, in which the voltage supply unit (9) is electrically coupled to the switching input (3), and a decoupled state, in which the voltage supply unit (9) is decoupled from the switching unit (3),
- a control device (7) for activating the switching unit (10), wherein the control device (7) can be supplied with electrical energy from the energy storage device (12), and
- an operating device (8) coupled to the control device (7), which can be supplied with electrical energy from the energy storage device (12) and by means of which the switching assembly (2) can be transferred between a wait state and an active state,

wherein the control device (7) is designed to transfer the switching unit (10) into the decoupled state after the energy storage device (12) has been charged in the wait state of the switching assembly (2), **characterised in that** the switching unit (10) comprises

- a semiconductor switch (48), by way of which the voltage supply unit (9) can be coupled to the switching input (3), wherein a coupled electric switch (57) is provided parallel to the semiconductor switch (48), and wherein the control device (7) is designed to switch the electric switch (57) into its electrically conducting switching state when the switching assembly (2) is transferred from the wait state into the active state,

- a storage unit (50), by way of which a control terminal (47) of the semiconductor switch (48) is coupled to the second input terminal (5) of the switching input (3), wherein the semiconductor switch (48) can be transferred into its electrically conducting switching state by charging the storage unit (50) with electrical energy without the control device (7) needing to output control signals to the switching unit (10), wherein between the control terminal (47) and the second input terminal (5, 38) and a voltage divider pole (42) the storage unit (50) is coupled to the control terminal and

- a tapping unit (39) coupled to the control terminal (47) of the semiconductor switch (48), which is embodied to tap the alternating supply voltage ($U_V$) at the switching input (3) and to provide an electrical voltage ($U_X$) derived therefrom to the storage unit (50), wherein the tapping unit (39) comprises a rectifying voltage divider which is coupled between the voltage divider pole (42) and the switching unit (3), said voltage divider being formed from a diode (40) and two resistors (41,44).

2. Switching assembly (2) according to claim 1, **characterised in that** the control device (7) is designed to hold the switching unit (10) in the decoupled state by discharging the storage unit (50), in particular by periodically discharging the storage unit (50).

3. Switching assembly (2) according to one of the preceding claims, **characterised in that** the control device (7) is designed to switch the switching unit (10) into the coupled state by pausing the discharging of the storage unit (50).

4. Switching assembly (2) according to one of the preceding claims, **characterised in that** the control device (7) is designed, in the wait state of the switching assembly (2), to hold the switching unit (10) in the decoupled state until the amplitude of the direct operating voltage ($U_B$) drops below a predetermined limit value.

5. Switching assembly (2) according to one of the preceding claims, **characterised in that** the control device (7) is designed to detect the amplitude of the direct operating voltage ($U_B$) and in the wait state of the switching assembly (2) to switch the switching unit (10) from the decoupled state into the coupled state if the direct operating voltage ($U_B$) drops below a predetermined limit value.

6. Switching assembly (2) according to one of the preceding claims, **characterised in that** the operating device (8) comprises a proximity sensor (115), in particular a capacitive proximity sensor (115), the input (116) of which is coupled to the voltage supply unit (9) and the output (29) of which is coupled to the control device (7), and the control device (7) is designed to evaluate an output signal (134) of the proximity sensor (115) and as a function of the result of this evaluation to detect an actuation of the proximity sensor (115) by an operating person.

7. Switching assembly (2) according to claim 6, **characterised in that** the proximity sensor (115) comprises:

 - a transistor (117), the collector which is coupled to the output (29) of the proximity sensor (115), and
 - a capacitor (122), the capacitance value of which can be changed by proximity and is coupled to a control terminal (119) of the transistor (117),

wherein the control terminal (119) and the emitter of the transistor (117) are coupled to the input (116) of the proximity sensor (115).

8. Switching assembly (2) according to claim 6 or 7, **characterised in that** the control device (7) is designed to trigger, at predetermined time intervals, in each case applying to the proximity sensor (115) a predetermined number of voltage pulses (133) from the energy storage device (12), in order to identify, on the basis of the output signal (134) of the proximity sensor (115), whether an operating person is actuating the proximity sensor (115), wherein the duration ($t_B$) of an individual voltage pulse (133) is in a value range of 10 μs to 50 μs and/or the time interval ($t_A$) between two consecutive voltage pulses (133) is in a value range of between 60 μs and 100 μs.

9. Switching assembly (2) according to one of claims 6 to 8, **characterised in that** the control device (7) is embodied to compare the output signal (134) of the proximity sensor (115) with a reference signal ($U_R$) and to identify, as a function of the comparison, whether an operating person is actuating the proximity sensor (115), wherein the control device (7) is preferably designed to determine the absolute amplitude of the output signal (134) of the proximity sensor (115) by changing the amplitude of the reference signal ($U_R$).

10. Switching assembly (2) according to one of claims 6 to 9, **characterised in that** the control device (7) is designed to confirm an actuation of the proximity sensor (115) by an operating person when the amplitude of a voltage pulse (134) of the output signal of the proximity sensor (115) is within a certain value range ($R_x$ to $Z_x$).

**11.** Switching assembly (2) according to claim 10, **characterised in that** after receiving a voltage pulse (134) of the output signal of the proximity sensor (115), the control device (7) is designed to determine once again the value range ($R_x$ to $Z_x$) for the evaluation of subsequent voltage pulses (134) as a function of the amplitude of the received voltage pulse (134).

**12.** Domestic appliance (1) with a switching assembly (2) according to one of the preceding claims.

**13.** Method for operating a switching assembly (2) in a domestic appliance (1), which can be transferred between a wait state and an active state, having the steps:

- applying an alternating supply voltage ($U_v$) to a switching input (3) of the switching assembly (2),
- switching a switching unit (10) from a decoupled state, in which a voltage supply unit (9) is decoupled from the switching input (3), into a coupled state, in which the voltage supply unit (9) is electrically coupled to the switching unit (3),
- providing a direct operating voltage ($U_B$) from the alternating supply voltage ($U_v$) by way of the voltage supply unit (9) and charging an energy storage device (12) with electrical energy, wherein the direct operating voltage ($U_B$) is applied to the energy storage device (12),
- transferring the switching unit (10) into the decoupled state after the energy storage device (12) has been charged,

**characterised by** the additional steps:

- tapping the alternating supply voltage ($U_V$) at the switching input (3) by means of a tapping unit (39) comprising a rectifying voltage divider coupled to the control terminal (47) of the semiconductor switch (48), and between the voltage divider pole (42) and the switching input (3), said voltage divider being formed from a diode (40) and two resistors (41, 44),
- providing an electrical voltage ($U_x$) derived from the alternating supply voltage ($U_V$) to a storage unit (50), by way of which a control terminal (47) of a semiconductor switch (48) is coupled to a second input terminal (5) of the switching input (3),
- transferring the semiconductor switch (48) into its electrically conducting switching state by charging the storage unit (50) with electrical energy and in this way
- coupling the voltage supply unit (9) to the switching input (3) by way of the semiconductor switch (48).

**Revendications**

**1.** Agencement de circuit (2) destiné au fonctionnement d'un appareil ménager (1), comprenant

- une entrée de circuit (3) munie d'une première et d'une deuxième bornes d'entrée (4, 5) pour coupler l'agencement de circuit (2) à un réseau d'alimentation (6) électrique, une tension alternative d'alimentation (Uv) du réseau d'alimentation (6) pouvant être appliquée à l'entrée de circuit (3),
- une unité d'alimentation en tension (9) qui est réalisée pour fournir une tension continue de fonctionnement ($U_B$) à partir de la tension alternative d'alimentation (Uv) et présente un accumulateur d'énergie (12) auquel la tension continue de fonctionnement ($U_B$) est appliquée,
- une unité de commutation (10) couplée entre l'entrée de circuit (3) et l'unité d'alimentation en tension (9), laquelle est électriquement couplée entre un état de couplage, dans lequel l'unité d'alimentation en tension (9) est électriquement couplée à l'entrée de circuit (3), et un état de découplage, dans lequel l'unité d'alimentation en tension (9) est découplée de l'entrée de circuit (3),
- un dispositif de commande (7) pour la commande de l'unité de commutation (10), le dispositif de commande (7) pouvant être alimenté en énergie électrique à partir de l'accumulateur d'énergie (12), et
- un dispositif d'actionnement (8) couplé au dispositif de commande (7), qui peut être alimenté en énergie électrique à partir de l'accumulateur d'énergie (12) et au moyen duquel l'agencement de circuit (2) peut passer d'un état d'attente à un état actif,

le dispositif de commande (7) étant configuré, après la charge de l'accumulateur d'énergie (12) dans l'état d'attente de l'agencement de circuit (2), pour faire passer l'unité de commutation (10) en l'état de découplage,
**caractérisé en ce que** l'unité de commutation (10) comprend

- un commutateur à semi-conducteur (48) par l'intermédiaire duquel l'unité d'alimentation en tension (9) peut être couplée à l'entrée de circuit (3), un commutateur électrique (57) couplé étant ménagé parallèlement au commutateur à semi-conducteur (48), et le dispositif de commande (7) étant conçu pour commuter le commutateur électrique (57) en son état de commutation électro-conducteur lorsque l'agencement de circuit (2) passe de l'état d'attente en l'état actif,
- une unité de mémorisation (50) par l'intermédiaire de laquelle une borne de contrôle (47) du commutateur à semi-conducteur (48) est couplée à la deuxième borne d'entrée (5) de l'entrée de circuit (3), le commutateur à semi-conducteur (48), en raison de la charge de l'unité de mémorisation (50) en énergie électrique, pouvant passer dans son état de commutation électro-conducteur sans que le dispositif de commande (7) n'émette nécessairement des signaux de commande à l'unité de commutation (10), l'unité de mémorisation (50) étant couplée à la borne de contrôle entre la borne de contrôle (47) et la deuxième borne d'entrée (5, 38) et un pôle de diviseur de tension (42), et
- une unité de prélèvement (39) couplée à la borne de contrôle (47) du commutateur à semi-conducteur (48), laquelle unité de prélèvement est réalisée pour prélever la tension alternative d'alimentation (Uv) à l'entrée de circuit (3) et pour fournir à l'unité de mémorisation (50) une tension ($U_X$) électrique qui en est dérivée, l'unité de prélèvement (39) comprenant un diviseur de tension redresseur, couplé entre le pôle de diviseur de tension (42) et l'entrée de circuit (3), lequel diviseur de tension est formé par une diode (40) et deux résistances (41, 44).

2. Agencement de circuit (2) selon la revendication 1, **caractérisé en ce que** le dispositif de commande (7) est conçu pour maintenir l'unité de commutation (10) dans l'état de découplage par décharge de l'unité de mémorisation (50), notamment par décharge périodique de l'unité de mémorisation (50).

3. Agencement de circuit (2) selon l'une quelconque des revendications précédentes, **caractérisé en ce que** le dispositif de commande (7) est conçu pour commuter l'unité de commutation (10) en l'état de couplage par interruption de la décharge de l'unité de mémorisation (50).

4. Agencement de circuit (2) selon l'une quelconque des revendications précédentes, **caractérisé en ce que** le dispositif de commande (7) est conçu, dans l'état d'attente de l'agencement de circuit (2), pour maintenir l'unité de commutation (10) dans l'état de découplage jusqu'à ce que l'amplitude de la tension continue de fonctionnement ($U_B$) dépasse vers le bas une valeur limite prédéterminée.

5. Agencement de circuit (2) selon l'une quelconque des revendications précédentes, **caractérisé en ce que** le dispositif de commande (7) est conçu pour détecter l'amplitude de la tension continue de fonctionnement ($U_B$) et, dans l'état d'attente de l'agencement de circuit (2), pour commuter l'unité de commutation (10) de l'état de découplage en l'état de couplage lorsque la tension continue de fonctionnement ($U_B$) dépasse vers le bas une valeur limite prédéterminée.

6. Agencement de circuit (2) selon l'une quelconque des revendications précédentes, **caractérisé en ce que** le dispositif d'actionnement (8) comprend un capteur de proximité (115), notamment un capteur de proximité (115) capacitif, dont l'entrée (116) est couplée à l'unité d'alimentation en tension (9) et dont la sortie (29) est couplée au dispositif de commande (7), et le dispositif de commande (7) étant conçu pour évaluer un signal de sortie (134) du capteur de proximité (115) et, en fonction du résultat de cette évaluation, pour identifier une confirmation du capteur de proximité (115) par une personne de service.

7. Agencement de circuit (2) selon la revendication 6, **caractérisé en ce que** le capteur de proximité (115) comprend :

- un transistor (117) dont le collecteur est couplé à la sortie (29) du capteur de proximité (115), et
- un condensateur (122) dont la valeur de capacité est modifiable par approche, et lequel est couplé à une borne de contrôle (119) du transistor (117),

la borne de contrôle (119) et l'émetteur du transistor (117) étant couplés à l'entrée (116) du capteur de proximité (115).

8. Agencement de circuit (2) selon la revendication 6 ou 7, **caractérisé en ce que** le dispositif de commande (7) est conçu pour entraîner à intervalles de temps prédéterminés respectivement une alimentation du capteur de proximité (115) avec un nombre prédéterminé d'impulsions de tension (133) à partir de l'accumulateur d'énergie (12) afin d'identifier à l'aide du signal de sortie (134) du capteur de proximité (115) si une personne de service actionne le capteur de proximité (115), la durée ($t_B$) d'une seule impulsion de tension (133) étant de préférence située dans une plage de valeur de 10 µs à 50 µs, et/ou l'écart temporel ($t_A$) entre deux impulsions de tension (133) se succédant étant situé dans une plage de valeur de 60 µs à 100 µs.

9. Agencement de circuit (2) selon l'une quelconque des revendications 6 à 8, **caractérisé en ce que** le dispositif de commande (7) est conçu pour comparer le signal de sortie (134) du capteur de proximité (115) avec un signal de référence ($U_R$) et, en fonction de la comparaison, pour identifier si une personne de service actionne le capteur de proximité (115), le dispositif de commande (7) étant de préférence conçu pour déterminer l'amplitude absolue du signal de sortie (134) du capteur de proximité (115) en raison de la modification de l'amplitude du signal de référence (U$_R$).

10. Agencement de circuit (2) selon l'une quelconque des revendications 6 à 9, **caractérisé en ce que** le dispositif de commande (7) est conçu pour confirmer un actionnement du capteur de proximité (115) par une personne de service lorsque l'amplitude d'une impulsion de tension (134) du signal de sortie du capteur de proximité (115) est située dans une plage de valeur prédéterminée (Rx à Zx).

11. Agencement de circuit (2) selon la revendication 10, **caractérisé en ce que** le dispositif de commande (7) est conçu, après la réception d'une impulsion de tension (134) du signal de sortie du capteur de proximité (115), pour déterminer de nouveau la plage de valeur (R$_X$ à Z$_X$) pour l'évaluation d'impulsions de tension (134) suivantes en fonction de l'amplitude de l'impulsion de tension (134) reçue.

12. Appareil ménager (1) comprenant un agencement de circuit (2) selon l'une quelconque des revendications précédentes.

13. Procédé de fonctionnement d'un agencement de circuit (2) dans un appareil ménager (1), lequel agencement de circuit peut commuter entre un état d'attente et un état actif, comprenant les étapes :

   - application d'une tension alternative d'alimentation (Uv) à une entrée de circuit (3) de l'agencement de circuit (2),
   - commutation d'une unité de commutation (10) d'un état de découplage, dans lequel une unité d'alimentation en tension (9) est découplée de l'entrée de circuit (3), en un état de couplage, dans lequel l'unité d'alimentation en tension (9) est électriquement couplée à l'entrée de circuit (3),
   - fourniture par l'unité d'alimentation en tension (9) d'une tension continue de fonctionnement (U$_B$) à partir de la tension alternative d'alimentation (Uv) et charge d'un accumulateur d'énergie (12) avec de l'énergie électrique, la tension continue de fonctionnement (U$_B$) étant appliquée sur l'accumulateur d'énergie (12),
   - passage de l'unité de commutation (10) en l'état de découplage après la charge de l'accumulateur d'énergie (12),

   **caractérisé par** les étapes supplémentaires :

   - prélèvement de la tension alternative d'alimentation (Uv) à l'entrée de circuit (3) par une unité de prélèvement (39) couplée à la borne de contrôle (47) du commutateur à semi-conducteur (48), comprenant un diviseur de tension redresseur, couplé entre le pôle de diviseur de tension (42) et l'entrée de circuit (3), formé par une diode (40) et deux résistances (41, 44),
- fourniture à une unité de mémorisation (50) d'une tension électrique (Ux) dérivée de la tension alternative d'alimentation (Uv), par l'intermédiaire de laquelle unité de mémorisation une borne de contrôle (47) d'un commutateur à semi-conducteur (48) est couplée à une deuxième borne d'entrée (5) de l'entrée de circuit (3),
- passage du commutateur à semi-conducteur (48) en son état de commutation électro-conducteur par charge de l'unité de mémorisation (50) avec de l'énergie électrique, et, en conséquence,
- couplage de l'unité d'alimentation en tension (9) à l'entrée de circuit (3) par l'intermédiaire du commutateur à semi-conducteur (48).

Fig.1

EP 2 315 338 B1

Fig.2

Fig.3

Fig.4

Fig.5

Fig.6

Fig.7

Fig.8

Fig.9a

Fig.9b

Fig.9c

Fig.9d

Fig.9e

**IN DER BESCHREIBUNG AUFGEFÜHRTE DOKUMENTE**

**In der Beschreibung aufgeführte Patentdokumente**

- EP 0689351 A2
- US 2009224603 A1
- DE 102005041113 A1